# EUROPEAN PATENT APPLICATION

(11) **EP 4 319 520 A1**
(43) Date of publication of application: **07.02.2024**
(21) Application number: 22807774.9
(22) Date of filing: 10.05.2022
(51) Int. Cl.: H05K 7/20, G02B 27/01

(54) **ELECTRONIC DEVICE AND METHOD FOR OPERATING ELECTRONIC DEVICE**

(30) Priority: 10.05.2021 KR 20210059951
(71) Applicant: Samsung Electronics Co., Ltd., Suwon-si, Gyeonggi-do 16677 (KR)
(72) Inventor: YANG, Hyunmo, Suwon-si Gyeonggi-do 16677 (KR); YANG, Sungkwang, Suwon-si Gyeonggi-do 16677 (KR); SONG, Joonyoung, Suwon-si Gyeonggi-do 16677 (KR); YOON, Jongmin, Suwon-si Gyeonggi-do 16677 (KR); CHO, Kyuhyung, Suwon-si Gyeonggi-do 16677 (KR); JO, Nammin, Suwon-si Gyeonggi-do 16677 (KR); HA, Heonjun, Suwon-si Gyeonggi-do 16677 (KR); KIM, Seungnyun, Suwon-si Gyeonggi-do 16677 (KR); LEE, Kihuk, Suwon-si Gyeonggi-do 16677 (KR)
(74) Representative: Gulde & Partner
(86) International application number: PCT/KR2022/006633
(87) International publication number: WO 2022/240126

(57) **Abstract**

An electronic device, according to one embodiment, comprises: a first housing having an accommodation space formed therein for accommodating a first external device; a second housing rotatably coupled to the first housing; and a cooling fan disposed in the inner space of the second housing, wherein the electronic device is configured to be transformed into a closed state or an open state according to the opening or closing of the second housing, wherein the second housing includes a second conduit part for communicating the inner space of the second housing with the accommodation space of the first housing, and the first housing includes a first conduit part communicating with the accommodation space and to which at least a portion of the second conduit part is connected in the closed state, and may be configured such that, in the closed state, wind generated by the cooling fan flows to the accommodation space through the first conduit part and the second conduit part.

## Description

### [Technical Field]

Various embodiments disclosed in the disclosure relate to an electronic device including a function of cooling an external electronic device, and a method for operating an electronic device.

### [Background Art]

According to recent development of technologies, various forms of wearable devices that may be mounted on a human body have been released. Among them, an augmented reality (AR) glass device is a wearable device that is mounted on the head of a user, and may provide an augmented reality service to the user by providing visual information through a display.

### [Disclosure]

### [Technical Problem]

The AR glasses (e.g., connective AR glasses) may be connected to a tethered device, such as a smartphone or a tablet PC. The AR glasses may be kept in a case, and may be charged and/or cooled through the case. The AR glasses may be connected to the tethered device, and may provide various functions by using resources of the tethered device.

For example, in case of, among various functions of the AR glasses, a holo call, cameras other than the cameras included in the AR glasses are necessary to display an image of the user to a counterpart. In this case, a measure for utilizing a camera of a portable communication device that is a tethered device of the AR glasses may be considered, but the user thereof may be limited by the emission of heat of the portable communication device.

Various embodiments disclosed in the disclosure may provide a case (e.g., an electronic device) that may cool AR glasses (e.g., a first external device) and a portable communication device (e.g., a second external device) connected to the AR glasses at the same time.

### [Technical Solution]

An electronic device according to an embodiment disclosed in the disclosure may include a first housing having a receiving space, in which a first external device is received, a second housing coupled to the first housing to be rotatable, and a cooling fan disposed in an interior space of the second housing, the electronic device may be deformed to a closed state and an opened state in correspondence to whether the second housing is opened or closed, the second housing may include a second passage part communicating the interior space of the second housing with the receiving space of the first housing, the first housing may include a first passage part communicated with the receiving space and to which at least a portion of the second passage part is connected in the closed state, in the closed state, wind generated by the cooling fan may flow to the receiving space through the first passage part and the second passage part, and the first external device may be received in the receiving space in the closed state to be cooled through the cooling fan.

In various embodiments, an operation method of an electronic device including the cooling fan according to an embodiment disclosed in the disclosure may include an operation of detecting a closed state or an opened state of the electronic device, an operation of recognizing a first external device or a second external device received in or held on the electronic device based on a state of the electronic device, an operation of acquiring temperature information of the first external device or the second external device, and an operation of controlling an operation and a rotational speed of the cooling fan based on the acquired temperature information.

### [Advantageous Effects]

The electronic device according to various embodiments disclosed in the disclosure may provide a function of keeping the first external device and a function of holding the second external device.

Furthermore, the electronic device according to various embodiments disclosed in the disclosure may cool the first external device when the first external device is received and cool the second external device when the second external device is held, in correspondence to a state of the electronic device, thereby enhancing the convenience of the user.

In addition, various effects directly or indirectly recognized through the disclosure may be provided.

### [Description of Drawings]

FIG. 1 illustrates an electronic device according to an embodiment and a first external device.
FIG. 2 illustrates a first external device according to an embodiment.
FIG. 3 illustrates a closed state of an electronic device according to an embodiment.
FIG. 4 illustrates an opened state of an electronic device according to an embodiment.
FIG. 5A illustrates an electronic device according to an embodiment.
FIG. 5B illustrates an electronic device according to an embodiment.
FIG. 6 illustrates a first housing and a second housing of an electronic device according to an embodiment.
FIG. 7 illustrates a first housing of an electronic device according to an embodiment.
FIG. 8 illustrates an operation of a cooling fan of an electronic device according to an embodiment, and flows of air.
FIG. 9 illustrates an electronic device according to an embodiment and a second external device.
FIG. 10 illustrates an electronic device according to an embodiment and a second external device.
FIG. 11 is a block diagram of an electronic device according to an embodiment.
FIG. 12 illustrates a method for operating an electronic device according to an embodiment.
FIG. 13 illustrates a method for operating an electronic device according to an embodiment.
FIG. 14 illustrates a method for operating an electronic device according to an embodiment.
FIG. 15 is a block diagram of an electronic device in a network environment according to various embodiments.

In relation to a description of the drawings, the same or similar components may be denoted by the same or similar reference numerals.

### [Mode for Invention]

Hereinafter, various embodiments of the disclosure will be described with reference to the accompanying drawings. However, it should be understood that the disclosure is not limited to specific embodiments and includes various modifications, equivalents, and/or alternatives of the embodiments of the disclosure.

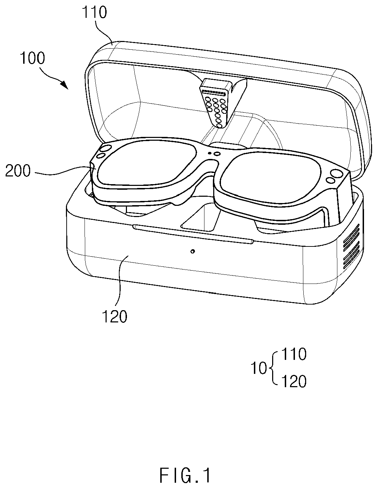

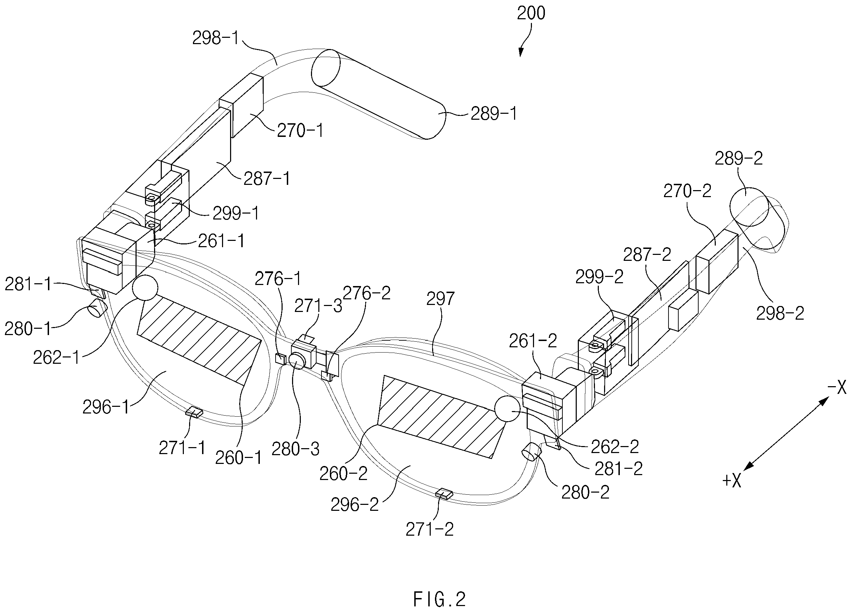

FIG. 1 illustrates an electronic device 100 according to an embodiment and a first external device 200. FIG. 2 illustrates the first external device 200 according to an embodiment.

FIG. 1 is a view illustrating a state, in which the first external device 200 is kept or accommodated in the electronic device 100. FIG. 2 is a schematic view schematically illustrating a structure and components of the first external device 200.

Referring to FIG. 1, the first external device 200 may be kept and/or accommodated in an interior of the electronic device 100 according to an embodiment. The electronic device 100 may be referenced as a case for keeping the first external device 200. For example, the electronic device 100 may provide a specific spaced for accommodating the first external device 200 in the interior thereof.

In an embodiment, the electronic device 100 may provide a function of charging the first external device 200. For example, the electronic device 100 may be configured to charge the first external device 200 when the first external device 200 is accommodated in the interior thereof. In various embodiments, the electronic device 100 may be a charging case provided with a charging system for the first external device 200. For example, the electronic device 100 may charge the first external device 200 by wire and/or wirelessly.

In an embodiment, the electronic device 100 may include a housing 10 including a first housing 120 and a second housing 110. For example, the housing 10 may be configured to define an external appearance of the electronic device 100 through coupling of the first housing 120 and the second housing 110. The second housing 110 may be coupled to the first housing 120 to be rotatable. For example, the second housing 110 may be coupled to one side of the first housing 120 to be rotatable, through a hinge. The second housing 110 may be rotated about the hinge with respect to the first housing 120 to be opened or closed. In various embodiments, the first housing 120 may be referred to as a first case, a lower case, or a body, and the second housing 110 may be referred to as a second case, an upper case, or a cover.

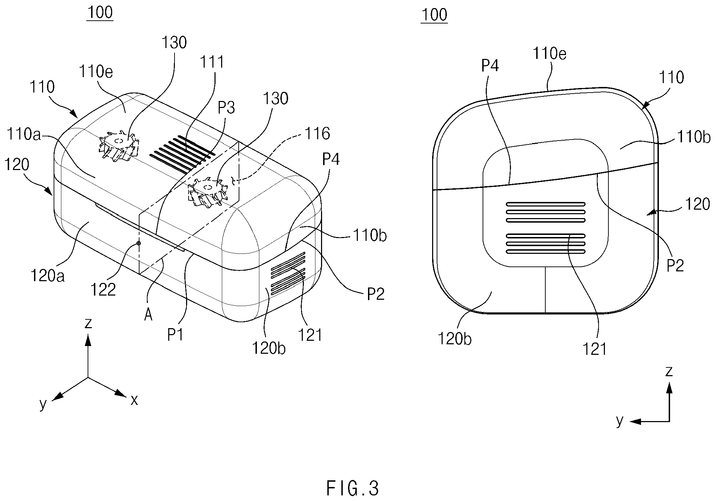

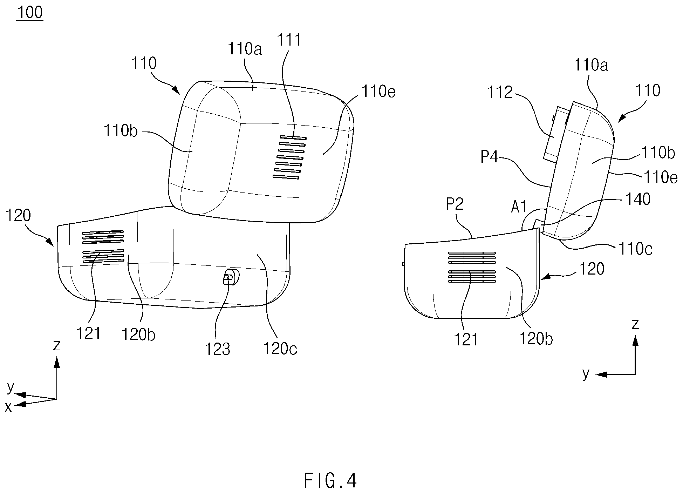

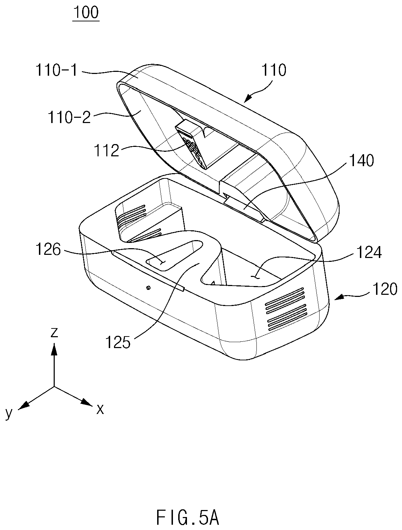

In an embodiment, the first housing 120 is adapted to receive the first external device 200, and a receiving space (not illustrated) (e.g., a receiving space 124 of FIGS. 5A to 7) may be formed in an interior thereof. The receiving space of the first housing 120 may be opened or sealed as the second housing 110 is rotated. For example, the second housing 110 may be arranged in the receiving space to be closed to seal the receiving space or be opened such that the receiving space is exposed. In various embodiments, the electronic device 100 may be deformed to the closed state and the opened state in correspondence to opening and closing of the second housing 110. The closed state and the opened state of the electronic device 100 will be described in more detail with reference to FIGS. 3 and 4 hereinafter.

In an embodiment, the electronic device 100 may provide a function of cooling the first external device 200 that is kept in the interior thereof. For example, the electronic device 100 may include a cooling fan (e.g., a cooling fan 130 of FIGS. 3, 6, and 8) for cooling the first external device 200. The electronic device 100 may communicate with the first external device 200, and may receive temperature information of the first external device 200 from the first external device 200. For example, the electronic device 100 may communicate with the first external device 200 through power line communication or short-range communication (e.g., BT, BLE, NFC, or WiFi) when the first external device 200 is accommodated/received in the interior thereof, and may acquire temperature information of the first external device 200. The electronic device 100 may cool the first external device 200 based on the temperature information of the first external device 200.

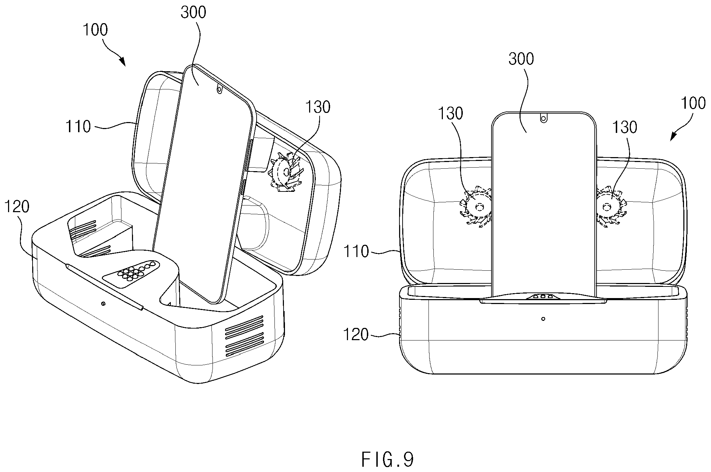

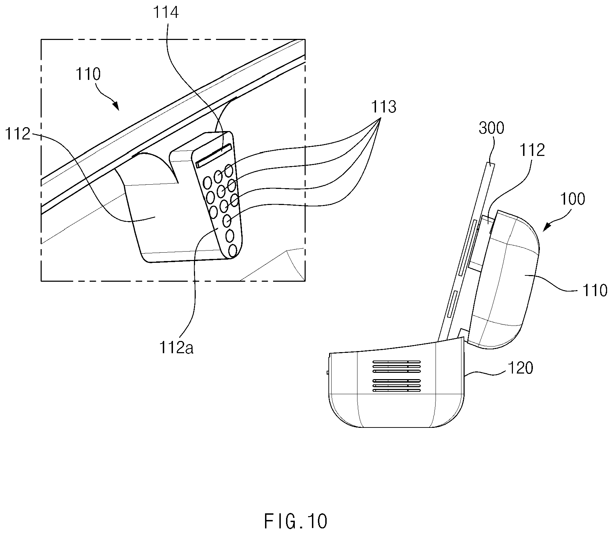

In various embodiments, the cooling fan may be configured to cool a third external device (e.g., a second external device 300 of FIGS. 9 and 10) when the third external device is held or seated on the electronic device 100. The electronic device 100 may communicate with the third external device, and may acquire temperature information of the third external device. The electronic device 100 may cool the third external device based on the temperature information.

Referring to FIG. 2, the first external device 200 according to an embodiment may be referenced as a head mounted device (HMD), a wearable device, smart glasses (e.g., AR glasses or VR glasses), or an eyewear. The form of the first external device 200 illustrated in FIG. 2 is exemplary, and the embodiments of the disclosure are not limited thereto. For example, the first external device 200 may be an arbitrary electronic device that is configured to provide augmented reality (AR) or virtual reality (VR).

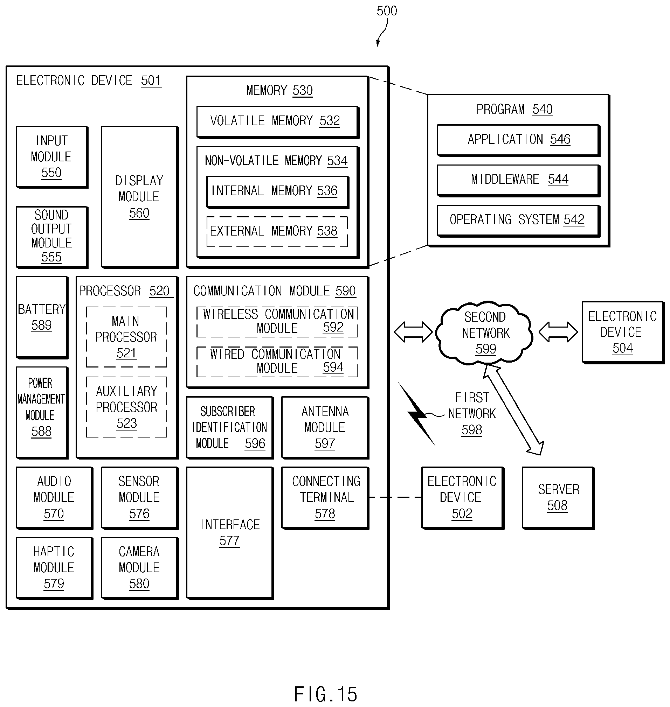

According to an embodiment, the first external device 200 may include at least some of the configurations of the electronic device 501 of FIG. 15. For example, the first external device 200 may include at least one of a display (e.g., a display module 560 of FIG. 15), a camera (e.g., a camera module 580 of FIG. 15), at least one sensor (e.g., a sensor module 576 of FIG. 15), a processor (e.g., a processor 520 of FIG. 15), a battery (e.g., a battery 589 of FIG. 15), a memory (e.g., a memory 530 of FIG. 15), or a communication circuit (e.g., a communication module 590 of FIG. 15). At least some of the configurations of the first external device 200 may be located in an interior of the housing of the first external device 200 or may be exposed to an outside of the housing.

The first external device 200 may include a display. For example, the first external device 200 may include a first display 261-1 and/or a second display 261-2. The first display 261-1 and/or the second display 261-2 may include at least one of a liquid crystal display (LCD), a digital mirror device (DMD), a liquid crystal on silicon (LCoS) device, an organic light emitting diode (OLED), or a micro light emitting device (micro LED). For example, the display of the first external device 200 may include at least one light source for irradiating light. When the first display 261-1 and/or the second display 261-2 includes one of a liquid crystal display, a digital mirror device, or a silicon liquid crystal display device, the first external device 200 may include at least one light source that irradiates light to a screen output area 260-1 and/or 260-2 of the display. As another example, when the display of the first external device 200 generates light by itself, the display may not include a separate light source other than the light source included in the display. When the first display 261-1 and/or the second display 261-2 includes at least one of an organic light emitting diode or a micro LED, the first external device 200 may provide an image to a user even though a separate light source is not included. When the display is implemented by an organic light emitting diode or a micro LED, a weight of the first external device 200 may be reduced through exclusion of a separate light source.

According to an embodiment, the first external device 200 may include a first transparent member 296-1 and/or a second transparent member 296-2. For example, when the user wears the first external device 200, the user may see through the first transparent member 296-1 and/or the second transparent member 296-2. The first transparent member 296-1 and/or the second transparent member 296-2 may be formed of at least one of a glass plate, a plastic plate, or a polymer, and may be transparent or semitransparent. For example, when be mounted, the first transparent member 296-1 may be disposed to face the right eye of the user, and the second transparent member 296-2 may be disposed to face the left eye of the user.

According to an embodiment, at least a portion of the first transparent member 296-1 and/or the second transparent member 296-2 may be a waveguide. For example, the waveguide may deliver the image generated by the display (e.g., the first display 261-1 and/or the second display 261-2) to the eyes of the user. The waveguide may be formed of glass, plastic, or a polymer. For example, the waveguide may include a nano pattern (e.g., a polygonal or curved grating structure) formed in an interior thereof or on one surface thereof. As an example, the light input to one end of the waveguide may be propagated in the interior of the waveguide by the nano pattern and may be provided to the eyes of the user. As an example, the waveguide including a free-form prism may be configured to provide the input light to the user through a reflective mirror.

According to an embodiment, the waveguide may include at least one of at least one diffractive element (e.g., a diffractive optical element (DOE)), a holographic optical element (HOE), or a reflective element (e.g., a reflective mirror). The waveguide may guide the light of the display, which is emitted from the light source part, to the eyes of the user by using at least one diffractive element or reflective element included in the waveguide. For example, the diffractive element may include an input optical member (e.g., 262-1 and/or 262-2) and/or an output optical member (not illustrated). The first input optical member 262-1 and/or the second input optical member 262-2 may be referenced as an input grating area, and the output optical member (not illustrated) may be referenced as an output grating area. The input grating area may diffract or reflect the light output from the light source (e.g., a micro LED) to deliver the light to the transparent member (e.g., the first transparent member 296-1 and/or the second transparent member 296-2) of the screen display part. The output grating area may diffract or reflect the light delivered to the transparent member (e.g., the first transparent member 296-1 and/or the second transparent member 296-2) of the waveguide toward the eyes of the user. For example, the reflective element may include a total reflection optical element or a total reflection waveguide for total internal reflection (TIR). The internal total reflection may be referenced as one scheme of guiding light, and may mean that light (e.g., an image) input through the input grating area is delivered to the output grating area substantially by 100% with an incident angle such that the light is reflected on one surface of the waveguide (e.g., a specific surface) substantially by 100%. In an embodiment, an optical path of the light emitted from the display may be guided to the waveguide by the input optical member. The light that travels to the interior of the waveguide may be guided toward the eyes of the user through the output optical member. The screen output area 260-1 and/or 260-2 may be determined based on the light emitted toward the eyes.

FIG. 2 illustrates that the first external device 200 provides an image to the user by using the waveguide, but the embodiments of the disclosure are not limited thereto. According to an embodiment, the display of the first external device 200 may be a transparent or semitransparent display. In this case, the display may be disposed at a location (e.g., the first screen output area 260-1 and/or the second screen output area 260-2) that faces the eyes of the user.

According to an embodiment, the first external device 200 may include at least one camera. For example, the first external device 200 may include a first camera 280-1, a second camera 280-2, and/or a third camera 280-3. For example, the first camera 280-1 and the second camera 280-2 may be used to recognize an external image. The first camera 280-1 and the second camera 280-2 may be configured to acquire an image corresponding to a direction (e.g., the +x direction) corresponding to a sight of the user. The first external device 200 may perform head tracking (e.g., a 3 degree of freedom (DoF) or a 6 degree of freedom), detection of a hand image, tracking of a hand image, and/or recognition of a space by using the first camera 280-1 and the second camera 280-2. As another example, the first camera 280-1 and the second camera 280-2 may be a global shutter (GS) camera having the same standard and performance (e.g., an angle of view, a shutter speed, a resolution, and/or the number of color bits). The first external device 200 may recognize a space (e.g., recognize a space of a 6 degree of freedom) and/or acquire depth information by using stereo cameras disposed on the left and right sides to support a simultaneous localization and mapping (SLAM) technology. Furthermore, the first external device 200 may recognize a gesture of the user by using the stereo cameras disposed on the left and right sides. The first external device 200 may detect a faster hand motion and a fine motion by using a GS camera having a relatively small distortion as compared with a rolling shutter (RS) camera. For example, a third camera 280-3 may be used to recognize an external image. The third camera 280-3 may be configured to acquire an image corresponding to a direction (e.g., the +x direction) corresponding to a sight of the user. In an embodiment, the third camera 2890-3 may be a camera that has a relatively high resolution as compared with those of the first camera 280-1 and the second camera 280-2. The third camera 280-3 may be referenced as a high resolution (HR) camera or a photo video (PV) camera. The third camera 280-3 may support functions for acquiring an image of a high screen quality, such as an auto focus (AF) and/or an optical image stabilization (OIS). The third camera 280-3 may be a GS camera or an RS camera.

According to an embodiment, the first external device 200 may include at least one eye-tracking sensor. For example, the first external device 20-0 may include a first eye-tracking sensor 276-1 and a second eye-tracking sensor 276-2. The first eye-tracking sensor 276-1 and the second eye-tracking sensor 276-2, for example, may be cameras that are configured to acquire an image in a direction corresponding to the eyes of the user. The first eye-tracking sensor 276-1 and the second eye-tracking sensor 276-2 may be configured to acquire a right eye image of the user and a left eye imaged of the user, respectively. The first external device 200 may be configured to detect the pupils of the user by using the first eye-tracking sensor 276-1 and the second eye-tracking sensor 276-2. The first external device 200 may acquire a sight of the user from the images of the pupils of the user, and may provide an image based on the acquired sight. For example, the first external device 200 may display an image such the image is located in a direction of the sight of the user. As an example, the first eye-tracking sensor 276-1 and the second eye-tracking sensor 276-2 may be a global shutter (GS) camera having the same standard and performance (e.g., an angle of view, a shutter speed, a resolution, and/or the number of color bits).

According to an embodiment, the first external device 200 may include at least one illumination unit. The illumination unit, for example, may include at least one LED. In FIG. 2, the first external device 200 may include a first illumination unit 281-1 and a second illumination unit 281-2. The first external device 200, for example, may provide auxiliary illuminations for the first camera 280-1, the second camera 280-2, and/or the third camera 28-3 by using the first illumination unit 281-1 and the second illumination unit 281-2. In an example, the first external device 200 may provide an illumination for acquiring images of the pupils by using the illumination unit (not illustrated). For example, the first external device 200 may provide an illumination for the eye-tracking sensor by using an LED of an infrared wavelength. In this case, the eye-tracking sensor may include an image sensor for acquiring an image of an infrared wavelength.

According to an embodiment, the first external device 200 may include at least one printed circuit board (PCB). For example, the first external device 200 may include a first PCB 287-1 located in a first temple 298-1 and a second PCB 287-2 located in a second temple 298-2. The first PCB 287-1 and/or the second PCB 287-2 may be connected to other components of the first external device 200 through signal lines and/or a flexible PCB. For example, a communication circuit, a memory, at least one sensor, and/or a processor may be disposed on the first PCB 287-1 and/or the second PCB 287-2. For example, each of the first PCB 287-1 and the second PCB 287-2 may include a plurality of PCBs that are spaced apart from each other by interposers.

According to an embodiment, the first external device 200 may include at least one battery. For example, the first external device 200 may include a first battery 289-1 located at one end of the first temple 298-1 and a second battery 289-2 located at one end of the second temple 298-2. The first battery 289-1 and the second battery 289-2 may be configured to supply electric power to the components of the first external device 200.

According to an embodiment, the first external device 200 may include at least one speaker. For example, the first external device 200 may include a first speaker 270-1 and a second speaker 270-2. The first external device 200 may be configured to provide stereo sounds by using speakers located on the left and right sides.

According to an embodiment, the first external device 200 may include at least one microphone. For example, the first external device 200 may include a first microphone 271-1, a second microphone 271-2, and/or a third microphone 271-3. The first microphone 271-1 may be located on the right side of a frame 297, the second microphone 271-2 may be located on the left side of the frame 297, and the third microphone 271-3 may be located in a bridge of the frame 297. In an example, the first external device 200 may perform beamforming by using the first microphone 271-1, the second microphone 271-2, and/or the third microphone 271-3.

According to an embodiment, the first external device 200 may include the first temple 298-1, the second temple 298-2, and the frame 297. The first temple 298-1, the second temple 298-2, and the frame 297 may be referenced as a housing. The first temple 298-1 may be physically connected to the frame 297 through a first hinge part 299-1, and may support the frame 297 when being mounted. The second temple 298-2 may be physically connected to the frame 297 through a second hinge part 299-2, and may support the frame 297 when being mounted.

The above-described configuration of the first external device 200 is exemplary, and the embodiments of the disclosure are not limited thereto. For example, the first external device 200 may not include at least some of the components described in relation to FIG. 2 or may further include components other than the described components. For example, the first external device 200 may include at least one sensor (e.g., an acceleration sensor, a gyro sensor, and/or a touch sensor) and/or an antenna.

FIG. 3 illustrates the closed state of the electronic device 100 according to an embodiment. FIG. 4 illustrates the opened state of the electronic device 100 according to an embodiment.

Referring to FIGS. 3 and 4, the electronic device 100 according to an embodiment may include the second housing 110, the first housing 120, the cooling fan 130, and a hinge 140.

The components of the electronic device 100 illustrated in FIGS. 3 and 4 may be the same as or similar to some of the components of the electronic device 100 illustrated in FIG. 1, and a repeated description thereof will be omitted hereinafter.

In an embodiment, an external appearance of the electronic device 100 may be defined by the second housing 110 and the first housing 120. In the illustrated embodiment, the electronic device 100 may have corners of a rounded rectangular shape, but this is exemplary and the shape of the electronic device 100 is not limited to the illustrated embodiment.

In an embodiment, the electronic device 100 may include the closed state and the opened state. As the second housing 110 is rotated about the hinge 140 with respect to the first housing 120, the electronic device 100 may be deformed to the closed state and the opened state. For example, the closed state of the electronic device 100 may refer to a state, in which the second housing 110 is fully closed, or a state, in which the first housing 120 is sealed, and the opened state of the electronic device 100 may refer to a state, in which the second housing 110 is fully opened, or a state, in which the first housing 120 is opened.

In an embodiment, the electronic device 100 may be deformed from the closed state to the opened state as the second housing 110 is rotated about the hinge 140 in a first rotational direction (e.g., the clockwise direction with respect to the drawing), and may be deformed from the opened state tot the closed state as the second housing 110 is rotated in a second rotational direction (e.g., the counterclockwise direction with respect to the drawing) that is opposite to the first rotational direction).

In an embodiment, the closed state and the second state may be determined according to an angle between the first housing 120 and the second housing 110, or whether they are in contact with each other. For example, the first housing 120 may include a first periphery P1 that extends in a long side direction (e.g., the x axis direction) and a second periphery P2 that extends in a short side direction (e.g., the y axis direction). The second housing 110 may include a third periphery P3 corresponding to the first periphery P1 and a fourth periphery P4 corresponding to the second periphery P2.

As illustrated in FIG. 3, the closed state may be a state, in which the peripheries P1 and P2 of the first housing 120 and the peripheries P3 and P4 of the second housing 110 are substantially in contact with each other. For example, the closed state may refer to a state, in which the first periphery P1 of the first housing 120 and the third periphery P3 of the second housing 110 are substantially in contact with each other and the second periphery P2 of the first housing 120 and the fourth periphery P4 of the second housing 110 are substantially in contact with each other. For example, the closed state may mean a state, in which the second periphery P2 and the fourth periphery P4 substantially form 0 degrees.

As illustrated in FIG. 4, the opened state may be a state, in which the peripheries P1 and P2 of the first housing 120- and the peripheries P3 and P4 of the second housing 110 are spaced apart from each other and the second housing 110 is rotated in a maximum range with respect to the first housing 120. For example, the opened state may be a state, in which the second housing 110 is supported or fixed not to be further rotated in the first rotational direction (e.g., the clockwise direction with respect to the drawing) with respect to the first housing 120. For example, the opened state may mean a state, in which an included angle A1 between the second periphery P2 and the fourth periphery P4 is a specific angle. In the opened state, the included angle A1 between the second periphery P2 and the fourth periphery P4 may be an obtuse angle (e.g., an angle that is larger than 90 degrees and smaller than 180 degrees).

According to various embodiments (e.g., see FIGS. 9 and 10) disclosed in the disclosure, in the opened state, the first external device (e.g., the first external device 200 of FIGS. 1 and 2) and another external device (e.g., the second external device 300 of FIGS. 9 and 10) that operatively and functionally interwork with the electronic device 100 may be held or seated on the electronic device 100. 3In consideration of the above embodiment, in the opened state, the included angle A1 between the second periphery P2 and the fourth periphery P4 may be about 100 degrees to 160 degrees, and preferably, may be about 110 degrees to 150 degrees. However, in the opened state, an angle defined by the second housing 110 and the first housing 120 is not limited to the above-described example, and may be changed according to various embodiments.

In an embodiment, the electronic device 100 may include a plurality of intermediate states defined between the closed state and the opened state. For example, the intermediate states may be understood as arbitrary states, in which the electronic device 100 is deformed from the closed state to the opened state or from the opened state to the closed state, and as sections, in which the state of the electronic device 100 is deformed. For example, the closed state and the opened state may be states, in which a specific shape (e.g., the shape of FIGS. 3 and 4) is maintained even when the external force of the user is removed, and the intermediate states may be states, in which a specific shape is not maintained to be deformed to any one of the closed state and the opened state when the external force is removed.

In various embodiments, the plurality of intermediate states of the electronic device 100 may include a free stop section, in which a specific shape is maintained between the opened state and the closed state. For example, in the free stop section, the included angle between the second periphery P2 and the fourth periphery P4 may be larger than 0 degrees and smaller than the included angle A1 in the opened state.

In an embodiment, the first housing 120 may define at least a portion of the external appearance of the electronic device 100 together with the second housing 110. The receiving space 124 may be formed in the interior of the first housing 120.

In an embodiment, the first housing 120 may define at least a portion of an outer surface of the electronic device 100. For example, the first housing 120 may define at least a portion of a side surface (e.g., a surface that faces the x axis or the y axis) of the electronic device 100 and at least a portion of a lower surface (e.g., a surface that faces the -z axis direction).

In an embodiment, the first housing 120 may include a plurality of side surfaces that define the side surface of the electronic device 100. The plurality of side surfaces of the first housing 120 may include a first side surface 120a, a second side surface 120b that extends from the first side surface 120a, a third side surface 120c that faces an opposite direction to the first side surface 120a, and a fourth side surface (not illustrated) that faces an opposite direction to the second side surface 120b. For example, the first side surface 120a may be a surface that faces the +y axis direction, the second side surface 120b may be a surface that faces the +x axis direction, the third side surface 120c may be a surface that faces the -y axis direction, and the fourth side surface (not illustrated) may be a surface that faces the -x axis direction.

In an embodiment, the first housing 120 may have at least one first vent hole 121 in at least a partial area of the outer surface thereof. For example, the first vent hole 121 may be formed in at least a partial area of the second surface 120b of the first housing 120. Although not illustrated, the first vent hole 121 also may be formed on the third side surface 120c of the first housing 120. The shape, the number, and the locations of the first vent holes 121 are not illustrated to the illustrated embodiment.

In an embodiment, the first vent hole 121 may pass through a partial area of the second side surface 120b of the first housing 120 such that an interior and an exterior of the first housing 120 are communicated with each other. For example, an aspect that the interior and the exterior of the first housing 120 are communicated with each other may mean that a fluid may flow between the interior and the exterior of the first housing 120. In various embodiments, the electronic device 100 may be configured such that the air flows from the interior to the exterior of the first housing 120 or from the exterior to the interior thereof, through the first vent hole 121.

In an embodiment, the first housing 120 may include a display part 122. For example, the display part 122 may be disposed on the first side surface 120a of the first housing 120. The display part 122 may be configured to display a state and/or an operation of the electronic device 100. For example, the display part 122 may include at least one light emitting element (e.g., an LED). However, the location of the display part 122 is not limited to the illustrated embodiment, and according to various embodiments, the display part 122 may be disposed in the second housing 110.

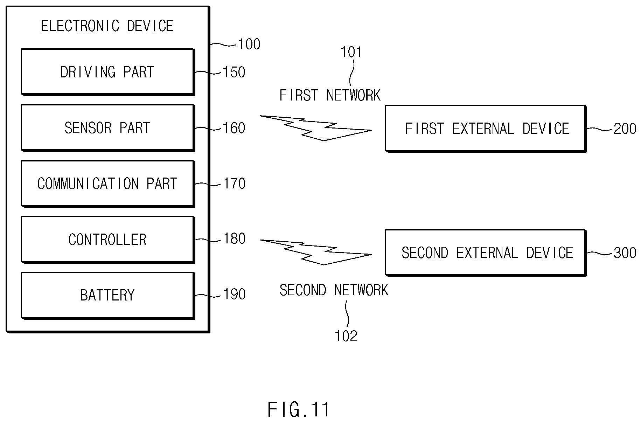

In an embodiment, the display part 122 may be configured to display a charging state of the battery (e.g., a battery 190 of FIG. 11) included in the electronic device 100 or display a charging state of the first external device (e.g., the first external device 200 of FIGS. 1 and 2) disposed in the interior of the electronic device 100. In various embodiments, the display part 122 may include a plurality of light emitting elements for displaying a charging state of the electronic device 100 and a charging state of the first external device 200. As another example, the display part 122 may be configured to display a current state of the electronic device 100 by emitting lights of different colors in correspondence to the opened state and the closed state of the electronic device 100.

In an embodiment, the first housing 120 may include a connector hole 123. For example, the connector hole 123 may be disposed on the third side surface 120c of the first housing 120. The connector hole 123 may be a configuration for accommodating an external connector. For example, the connector hole 123 may accommodate a connector (e.g., a USB connector) for transmitting and/or receiving electric power to and from an external electronic device (e.g., a charging device). In various embodiments, the electronic device 100 may be physically and/or electrically connected to the external electronic device 100 through the connector (not illustrated) inserted into the connector hole 123.

In an embodiment, the second housing 110 may define at least a portion of the external appearance of the electronic device 100 together with the first housing 120. The second housing 110 may be coupled to the first housing 120 to be rotatable, through the hinge 140.

In an embodiment, the second housing 110 may define at least a portion of the outer surface of the electronic device 100. For example, the second housing 110 may define at least a portion of the side surface (e.g., a surface that faces the x axis or the y axis) of the electronic device 100 and at least a portion of an upper surface (e.g., a surface that faces the +z axis direction in the closed state). For example, the upper surface may mean a surface of the electronic device 100, which faces an opposite direction to the lower surface thereof in the closed state.

In an embodiment, the second housing 110 may include a plurality of side surfaces 110a, 110b, and 110c that define side surfaces of the electronic device 100 together with the side surfaces 120a, 120b, and 120c of the first housing 120. The plurality of side surfaces 110a, 110b, and 110c of the second housing 110 may include a fifth side surface 110a, a sixth side surface 110b that extends from the fifth side surface 1 10a, a seventh side surface 110c that faces an opposite direction to the fifth side surface 110a, and an eighth side surface (not illustrated) that faces an opposite direction to the sixth side surface 110b. For example, the fifth side surface 110a may be a surface that faces the +y axis direction, the sixth side surface 110b may be a surface that faces the +x axis direction, the seventh side surface 110c may be a surface that faces the -y axis direction, and the eighth side surface (not illustrated) may be a surface that faces the -x axis direction. For example, when the electronic device 100 is in the closed state, the fifth side surface 110a of the second housing 110 may correspond to the first side surface 120a of the first housing 120, the sixth side surface 110b of the second housing 110 may correspond to the second side surface 120b of the first housing 120, the seventh side surface 110c of the second housing 110 may correspond to the third side surface 120c of the first housing 120, and the eighth side surface (not illustrated) of the second housing 110 may correspond to the fourth side surface (not illustrated) of the first housing 120.

In an embodiment, the second housing 110 may include a first surface 110e that extends from the plurality of side surfaces 110a, 110b, and 1 10c, and the first surface 110e may define at least a portion of the upper surface of the electronic device 100. Although not illustrated, the second housing 110 may include a second surface (not illustrated) that faces an opposite direction to the first surface 110e, and the plurality of side surfaces may surround a space between the first surface 110e and the second surface. For example, an interior space 116 may be defined in an interior of the second housing 110 by the plurality of side surfaces 1 10a, 110b, and 110c, the first surface 110e, and the second surface (not illustrated) that faces an opposite direction to the first surface 110e, and the cooling fan 130 may be disposed in the interior space 116.

In an embodiment, the second housing 110 may have at least one second vent hole 111 in at least a partial area of an outer surface thereof. For example, the second vent hole 111 may be formed in at least a partial area of the first surface 110e of the second housing 110. The shape, the number, and the locations of the second vent holes 111 are not limited to the illustrated embodiment. According to various embodiments, the second vent hole 111 may be formed on a side surface (e.g., the plurality of side surfaces 110a, 110b, and 110c) of the second housing 110.

In an embodiment, the second vent hole 111 may pass through a partial area of the first surface 110e of the second housing 110 such that the interior space 116 and an outside of the second housing 110 are communicated with each other. For example, an aspect that the interior space 116 and the outside of the second housing 110 are communicated with each other may mean that a fluid may flow between the interior space and the outside of the second housing 110. In various embodiments, the electronic device 100 may be configured such that the air flows from the interior space 116 to the outside of the second housing 110 or from the outside to the interior space 116 thereof through the second vent hole 111.

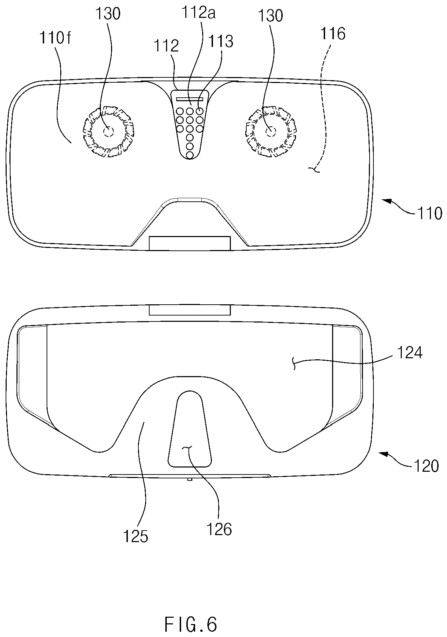

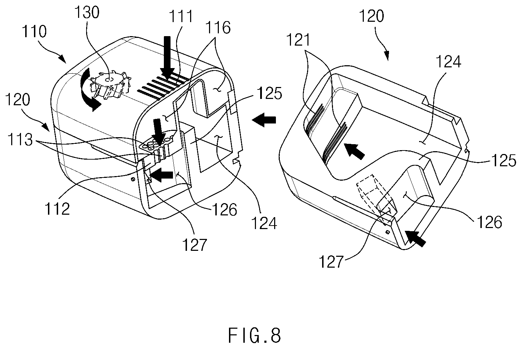

In an embodiment, the second housing 110 may include a second passage part such that the wind generated by the cooling fan 130 flows to the outside of the second housing 110. For example, the second passage part 112 may protrude from one surface (e.g., a surface that faces an opposite direction to the first surface 110e) of the second housing 110. The second passage part 112 may have a plurality of through-holes (e.g., a through-hole 113 of FIG. 6) that is communicated with the interior space 116 of the second housing 110. In various embodiments, the wind generated by the cooling fan 130 may flow to the outside of the interior space 116 through the through-hole 113 of the second passage part 112. The flows of the air by the cooling fan 130 will be descried in more detail hereinafter with reference to FIG. 8.

In an embodiment, the cooling fan 130 may be disposed in the interior of the second housing 110. The cooling fan 130 may be configured to be rotated by a driving part (not illustrated) (e.g., a driving part 150 of FIG. 11). For example, the cooling fan 130 may be configured to lower a temperature of the first external device (e.g., the first external device 200 of FIGS. 1 and 2) received in the electronic device 100 or the second external device (e.g., the second external device 300 of FIGS. 9 and 10) held on the electronic device 100, by generating wind. In various embodiments, the cooling fan 130 may be a device that is rotated to blow air outside the electronic device 100 in such that the air may flow into the interior of the second housing 110 through the second vent hole 111.

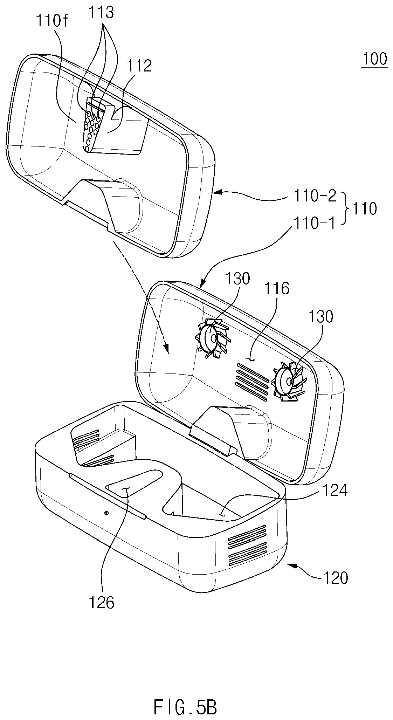

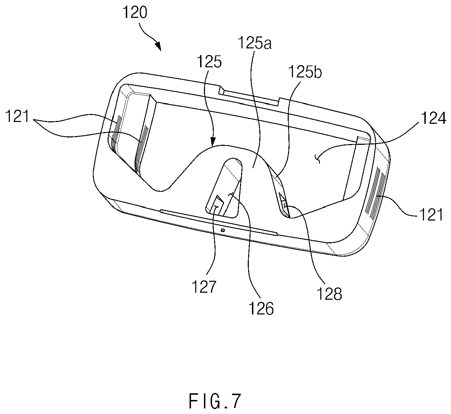

FIG. 5A illustrates the electronic device 100 according to an embodiment. FIG. 5B illustrates the electronic device 100 according to an embodiment. FIG. 6 illustrates the second housing 110 and the first housing 120 of the electronic device 100 according to an embodiment. FIG. 7 illustrates the first housing 120 of the electronic device 100 according to an embodiment.

FIG. 5A may be a view illustrating, among the intermediate states of the electronic device 100, an arbitrary state. FIG. 5B may be a view illustrating a state, in which the second housing 110 of the electronic device 100 is disassembled. FIG. 6 is a plan view of the second housing 110 and the first housing 120 of the electronic device 100. FIG. 7 is a perspective view of the first housing 120.

For example, the second housing 110 illustrated in FIG. 6 may correspond to a view, in which a second surface 110f of the second housing 110 is viewed from a top (e.g., the z axis direction of FIG. 5A), and the first housing 120 illustrated in FIG. 6 may be a view, in which the receiving space 124 of the first housing 120 is viewed from a top.

Referring to FIGS. 5A to 7, the electronic device 100 according to an embodiment may include the first housing 120, the second housing 110 that is coupled to the first housing 120 to be rotatable, the cooling fan 130 that is disposed in the interior of the second housing 110, and the hinge 140 that connect the second housing 110 and the first housing 120 such that they are rotatable.

The components of the electronic device 100 illustrated in FIGS. 5A to 7 may be the same as or similar to some of the components of the electronic device 100 illustrated in FIGS. 1, 3, and 4, and a repeated description thereof will be omitted hereinafter.

In an embodiment, the first housing 120 may have the receiving space 124 in the interior thereof. For example, at least a portion of the first external device 200 may be accommodated in the receiving space 124. The receiving space 124 may be defined by an inner surface of the first housing 120. For example, the receiving space 124 may have a shape corresponding to that of the first external device (e.g., the first external device 200 of FIGS. 1 and 2). Hereinafter, in a description of FIGS. 5A to 7, the first external device 200 may be referenced as the first external device 200 illustrated in FIGS. 1 and 2.

In an embodiment, the receiving space 124 may be communicated with the outside of the first housing 120 through the vent hole 121 formed on a side surface of the first housing 120. For example, the first vent hole 121 may pass from the outer surface to the inner surface of the first housing 120 to be connected to the receiving space 124. In various embodiments, the air may flow from the receiving space 124 to the outside of the first housing 120 or from the outside of the first housing 120 to the receiving space 124, through the first vent hole 121.

Although not illustrated, a charging pad (not illustrated) for charging the first external device 200 may be disposed at at least a portion of the receiving space 124 of the first housing 120. The charging pad may be connected to the first external device 200 such that electric power may be supplied to a battery (e.g., the battery 289-1 and 289-2 of FIG. 2) of the first external electronic device 100 wherein the battery (e.g., the battery 190 of FIG. 11) of the electronic device 100 is received in the receiving space 124. For example, the electronic device 100 may charge the battery 190 of the first external device 200 as the charging pad electrically contacts the first external device 200.

In various embodiments, the charging pad (not illustrated) may be a pad (or a conductive area) formed of a conductive material, and the charging pad may contact a charging terminal (e.g., a pogo pin) of the first external device 200. For example, the charging pad may be disposed at a location, at which it may contact the charging terminal of the first external device 200 when the first external device 200 is received in the receiving space 124 of the first housing 120. However, the configuration for charging the first external device 200 is not limited to the above-described example, and may be implemented by using various methods (e.g., wireless charging).

In an embodiment, the first housing 120 may include a first passage part 125. For example, the first passage part 125 may be formed as at least a portion of the inner surface of the first housing 120 extends toward the receiving space 124. For example, the inner surface of the first housing 120 may mean side surfaces in the interior of the first housing 120, which define the receiving space 124. For example, the first passage part 125 may be formed such that at least a portion thereof is located between a pair of transparent members (e.g., a first transparent member 296-1 and a second transparent member 296-2 of FIG. 2) of the first external device 200.

In an embodiment, the first passage part 125 may be configured to be connected to the second passage part 112. When the electronic device 100 is in the closed state (e.g., the state of FIG. 3), the first passage part 125 may be connected to the second passage part 112 such that the wind generated by the cooling fan 130 flows toward the receiving space 124. For example, the first passage part 125 may be configured such that at least a portion of the second passage part 112 is inserted into a portion (e.g., a first opening 126) of the first passage part 125 when the second housing 110 is closed.

In an embodiment, the first passage part 125 may include a plurality of openings 126, 127, and 128. The plurality of openings 126, 127, and 128 of the first passage part 125 may include a first opening 126, into which at least a portion of the second passage part 112 is inserted, and a second opening 127 and a third opening 128 that extend from the first opening 126 to connect the interior space 116 and the first opening 126. For example, the second opening 127 and the third opening 128 may extend from at least a portion of the first opening 126 substantially in an opposite direction to be symmetrical to each other with respect to the first opening 126.

In an embodiment, the first passage part 125 may include a first area 125a that faces the second housing 110 in the closed state, and a second area 125b that extends from the first area 125a to be substantially perpendicular thereto and is a partial area of the inner surface of the first housing 120. For example, the first opening 126 may pass through at least a portion of the first area 125a, and the second opening 127 and the third opening 128 may extend from the first opening 126 to pass through at least a portion of the second area 125b.

In an embodiment, the first opening 126 may be formed to have a shape corresponding to the second passage part 112 such that at least a portion of the second passage part 112 is inserted thereinto when the electronic device 100 is in the closed state. For example, the first opening 126 may be formed to larger than the second passage part 112 by a specific size such that at least a portion of the second passage part 112 is inserted thereinto.

In an embodiment, the second opening 127 may provide a flow path such that the wind that flows from the second passage part 112 flows toward a heat emitting portion of the first external device 200 received in the receiving space 124. For example, the wind that is discharged from the second passage part 112 (e.g., the through-hole 113) may flow toward a heat emitting part (e.g., the first PCB 287-1 and the second PCB 287-2) located at a leg portion (e.g., the first temple 298-1 and the second temple 298-2) of the first external device 200.

According to an embodiment, the electronic device 100 may be configured such that the wind generated by the cooling fan 130 flows to a portion of the first external device 200, at which a main light emitting source is located, through the first opening 126, the second opening 127, and/or the third opening 128.

In an embodiment, the cooling fan 130 may be disposed in the interior of the second housing 110. For example, the cooling fan 130 that is rotated by a driving part (e.g., a motor) may be accommodated in the interior space 116 of the second housing 110.

In an embodiment, the second housing 110 may include a first cover 110-1 and a second cover 110-2. For example, the second housing 110 may be formed through coupling of the first cover 110-1 and the second cover 110-2. In various embodiments, the first cover 110-1 may be referenced as an outer cover, and the second cover 110-2 may be referenced as an inner cover.

In an embodiment, the cooling fan 130 may be disposed in the interior 116 of the first cover 110-1, and the second cover 110-2 may be coupled to the first cover 110-1 to cover the interior space 116 of the first cover 110-1 and the cooling fan 130. For example, as the first cover 110-1 and the second cover 110-2 of the second housing 110 are coupled to each other, the interior space 116 and the cooling fan 130 are hidden not to be visually exposed. In various embodiments, when the first cover 110-1 and the second cover 110-2 are coupled to each other, the cooling fan 130 may be located in a space between the first cover 110-1 and the second cover 110-2. For example, the second cover 110-2 may be formed such that a height thereof is smaller than a height of the first cover 110-1 such that a spacing space is formed between the first cover 110-1 and the second cover 110-2. Accordingly, when the second cover 110-2 is coupled to the first cover 110-1, a space, in which the cooling fan 130 may be disposed, may be secured between the first cover 110-1 and the second cover 110-2.

In an embodiment, the second passage part 112 may be formed in the second cover 110-2. For example, the second cover 110-2 may be coupled to the first cover 110-1, and the second passage part 112 of the second cover 110-2 may be fluid-communicated with the interior space 116 of the first cover 110-1. When the second cover 110-2 is coupled to the first cover 110-1, the interior space 116 and the cooling fan 130 may be hidden by the second surface 110f of the second cover 110-2. For example, the second surface 110f of the second cover 110-2 may define an outer surface of the second housing 110.

According to the embodiment illustrated in FIG. 5B, the second housing 110 may be provided by a structure, in which the first cover 110-1 and the second cover 110-2 are coupled to each other, but this is exemplary and the structure of the second housing 110 is not limited to the embodiment. For example, the second housing 110 may be provided by a structure, in which the first cover 110-1 and the second cover 110-2 are integral such that an empty space is formed in the interior thereof.

In an embodiment, the interior space 116 of the second housing 110 may be communicated with an outside of the second housing 110 through a second vent hole (e.g., the second vent hole 111 of FIGS. 3 and 4) formed on the outer surface of the second housing 110. For example, the second vent hole 111 may pass through at least a partial area of the first surface (e.g., the first surface 110e of FIGS. 3 and 4) of the second housing to be connected to the interior space 116. In various embodiments, the air may flow from the outside to the interior space 116 of the second housing 110 or flow from the interior space 116 to the outside of the second housing 110, through the second vent hole 110.

In an embodiment, the second housing 110 may include the second passage part 112. For example, the second passage part 112 may extend from at least a partial area of the second surface 110f of the second housing 110 (or the second cover 110-2) in a direction that is substantially perpendicular to the second surface 110f. For example, the second passage part 112 may protrude from the second surface 110f such that at least a portion thereof is inserted into the first opening 126 in the closed state.

In an embodiment, the second passage part 112 may be configured to be connected to the first passage part 125. The second passage part 112 may be connected to the first passage part 125 such that the wind generated by the cooling fan 130 flows toward the receiving space 124 when the electronic device 100 is in the closed state (e.g., the state of FIG. 3). For example, at least a portion of the second passage part 112 may be inserted into the first opening 126 of the first passage part 125 when the second housing 110 is closed.

In an embodiment, the second passage part 112 may be formed to have a shape corresponding the first opening 126 such that at least a portion thereof is inserted into the first opening 126. For example, the second passage part 112 may be formed to be smaller than the first opening 126 by a specific size to be inserted into the first opening 126 or be extracted from the first opening 126 in correspondence to rotation of the second housing 110. The second passage part 112 may be formed at a location, at which it is aligned with the first opening 126 of the first passage part 125 in the closed state.

In an embodiment, the second passage part 112 may include at least one through-hole 113. The through-hole 113 may be communicated with the interior space 116, and may pass through an outer surface of the second passage part 112. For example, the through-hole 113 may extend from a first area 112a of the second passage part 112, which faces substantially the same direction as the second surface 110f, toward the interior space 116. For example, as the second passage part 112 is inserted into the first opening 126 of the first passage part 125 in the closed state, the through-hole 113 may be communicated with the first opening 126 and the second opening 127 (and/or the third opening 128), and the interior space 116 may be communicated with the through-hole 113, the first opening 126, and the second opening 127 (and/or the third opening 128).

In the embodiment illustrated in FIG. 6, the second passage part 112 may include a plurality of through-holes 113 that are formed in the first area 112a to be spaced apart from each other, but the shape of the through-holes 113 is not limited thereto. In various embodiments, the through-hole may be deformed to a shape, in which one large hole is formed, similarly to the first opening 126 of the first passage part 125.

In an embodiment, the second passage part 112 may support a third external device (e.g., the second external device 300 of FIGS. 9 and 11) that is different from the first external device 200 in the opened state of the electronic device 100. The electronic device 100 according to an embodiment may be configured to cool the third external device by using the cooling fan 130 when the third external device is held or seated on the second passage part 112. An operation of cooling the third external device 300 will be described in more detail with reference to FIGS. 9 and 10 hereinafter.

In an embodiment, the cooling fan 130 may be disposed in the interior of the second housing 110, and may be operatively connected to some components (e.g., the battery 190 and/or a controller 180 of FIG. 11) of the electronic device 100. For example, the cooling fan 130 may be configured to receive electric power from some parts (e.g., the battery 190 of FIG. 11) of the electronic device 100 to be rotated. The cooling fan 130 may include wing parts (not illustrated) that is driven to be rotated, and a driving part (not illustrated) (e.g., a motor) that is connected to the wing parts and is configured to rotate the wing parts. For example, the driving part may rotate the wing parts by using the electric power received from the battery 190 of the electronic device 100, and the wing parts may generate wind by the flows of air while being rotated.

In an embodiment, the cooling fan 130 may include a first cooling fan 130 and a second cooling fan 130, which are located on opposite sides of the second passage part 112. For example, the first cooling fan 130 and the second cooling fan 130 may be disposed to be symmetrical to each other with respect to the second passage part 112. The first cooling fan 130 and the second cooling fan 130 may have substantially the same shape. However, the location and/or number of the cooling fan 130 are not limited to the illustrated embodiment, and may be changed according to various embodiments.

In an embodiment, the cooling fan 130 may be configured to be operated based on a heat emission degree of the external device (e.g., the first external device 200 and/or the second external device 300). For example, the cooling fan 130 may be operated when a temperature of the first external device 200 and/or the second external device 300 is in a specific range or more. In various embodiments, an operation of the cooling fan 130 may be controlled by a controller (e.g., the controller 180 of FIG. 11). For example, whether the cooling fan 130 is operated, and a rotational speed and/or a strength of the wind of the cooling fan 130 may be controlled by the controller 180.

In an embodiment, the cooling fan 130 may circulate the air in the interior of the electronic device 100 in the closed state. For example, the cooling fan 130 may blow the air outside the electronic device 100 into the interior (e.g., the interior space 116 of the second housing 110 and the receiving space 124 of the first housing 120) of the electronic device 100, and the air in the interior of the electronic device 100 may be discharged to the outside of the electronic device 100 through the first vent hole 121. An operation of the air being circulated by the cooling fan 130 in the closed state of the electronic device 100 will be described in more detail with reference to FIG. 8 hereinafter.

FIG. 8 illustrates an operation of the cooling fan 130 of the electronic device 100 according to an embodiment, and flows of the air.

FIG. 8 may be a view illustrating an operation of the air being circulated through an operation of the cooling fan 130 when the electronic device 100 is in the closed state. For example, FIG. 8 may be a view illustrating section "A" of the electronic device 100 illustrated in FIG. 3.

Referring to FIG. 8, the electronic device 100 according to an embodiment may be configured to circulate the air between the inside and the outside of the electronic device 100 as the cooling fan 130 is operated in the closed state. For example, the electronic device 100 may cool heat of the first external device (e.g., the first external device 200 of FIGS. 1 and 2) received in the interior thereof, in an air cooling scheme.

In an embodiment, the electronic device 100 may include the second housing 110, the first housing 120, and the cooling fan 130, and the structures and components of the second housing 110, the first housing 120, and the cooling fan 130 illustrated in FIG. 8 are substantially the same as or similar to those of the second housing 110, the first housing 120, and the cooling fan 130 illustrated in FIGS. 5A to 7, and thus, a repeated description thereof will be omitted.

In an embodiment, when the electronic device 100 is in the closed state, the second passage part 112 of the second housing 110 may be connected (coupled) to the first passage part 125 of the first housing 120. For example, at least a portion of the second passage part 112 may be inserted into the first opening 126 of the first passage part 125. Accordingly, the interior space 116 of the second housing 110 may be communicated with the receiving space 124 of the first housing 120 through the through-hole 113 of the second passage part 112, and the plurality of openings 126, 127, and 128 of the first passage part 125. For example, the air in the interior space 116 may flow to the receiving space 124 through the through-hole 113, the first opening 126, the second opening 127, and/or the third opening 128.

In an embodiment, the cooling fan 130 may be operated through control of the electronic device 100. When the cooling fan 130 is operated, the air outside the electronic device 100 may be rotated to be introduced into the interior space 116 after passing through the second vent hole 111 of the second housing 110.

In an embodiment, the air introduced into the interior space 116 may flow to the first opening 126 through the through-hole 113, and the air that flows to the first opening 126 may flow to the receiving space 124 through the second opening 127 (or the third opening (e.g., the third opening 128 of FIG. 7)). For example, the flows of the air generated by the cooling fan 130 may act as wind for cooling the heat of the first external device 200 received in the receiving space 124.

In an embodiment, the air introduced into the receiving space 124 may be discharged to the outside of the electronic device 100 through the first vent hole 121 of the first housing 120. For example, the cooling fan 130 may cause the air that flows along the second vent hole 111, the interior space 116, the through-hole 113, the first opening 126, the second opening 127 (or the third opening 128), and the first vent hole 121 to flow and circulate, and through this, the heat generated by the first external device 200 may be cooled.

In an embodiment, the electronic device 100 may be configured such that the first passage part 125 is connected to the second passage part 112 in the closed state and the second opening 127 or the third opening 128 is located adjacent to the heat emitting portion of the first external device 200. That is, the electronic device 100 may enhance a cooling effect of the first external device 200 using the cooling fan 130 through a connection structure of the second passage part 112 and the first passage part 125.

In an embodiment, the electronic device 100 may operate the cooling fan 130 in the opened state to generate flows of the air that flows along the second vent hole 111, the interior space 116, and the through-hole 113. According to various embodiments disclosed in the disclosure, a third external device (e.g., the second external device 300 of FIGS. 9 and 10) may be held on the electronic device 100 in the opened state, and the flows of the air discharged from the through-hole 113 may act as wind for cooling the heat of the third external device 300 supported by the first passage part 125.

FIG. 9 illustrates the electronic device 100 and the second external device 300 according to an embodiment. FIG. 10 illustrates the electronic device 100 and the second external device 300 according to an embodiment.

FIGS. 9 and 10 may be views illustrating a state, in which the second external device 300 is held on the electronic device 100 in the opened state of the electronic device 100.

Referring to FIGS. 9 and 10, the electronic device 100 according to an embodiment may be configured such that the second external device 300 is held and/or seated on at least a portion of the electronic device 100 in the opened state (e.g., the state of FIG. 4).

In an embodiment, the electronic device 100 may be fixed such that the second housing 110 is maintained in a state, in which it is rotated by a specific angle with respect to the first housing 120 in the opened state, and a portion of the second external device 300 may be supported by the second housing 110 to be held on the electronic device 100. In various embodiments, an angle (e.g., the included angle A1 of FIG. 4) between the second housing 110 and the first housing 120 in the opened state may be set to an angle, by which the user may easily view a screen of the second external device 300 held in the electronic device 100 or a camera.

In an embodiment, the first housing 120 and the second housing 110 may support the second external device 300. The receiving space 124 of the first housing 120 and the second passage part 112 of the second housing 110 may contact the second external device 300 such that the second external device 300 is stably held on the electronic device 100.

In an embodiment, the second passage part 112 may include a support boss 114 for spacing the second external device 300 apart from the first area 112a of the second passage part 112 by a specific interval. The support boss 114 may form a gap between the second external device 300 and the first through-hole 113 to implement a structure, in which the second external device 300 is air-cooled.

In an embodiment, a portion of the second external device 300 may be disposed in the interior of the receiving space 124 of the first housing 120, and another portion thereof may be held on the electronic device 100 that is supported while contacting the second housing 110.

In an embodiment, when the second external device 300 is held on the electronic device 100, the second external device 300 may contact the second passage part 112 of the second housing 110. For example, the second external device 300 may be disposed to face the first area 112a of the second passage part 112.

In an embodiment, the second external device 300 may cool the heat through the cooling fan 130 in a state, in which it is held on the electronic device 100. For example, when the cooling fan 130 is operated in a state, in which the second external device 300 is held on the electronic device 100, the air that flows through the through-hole 113 of the second passage part 112 may reach the second external device 300, and through this, the heat generated by the second external device 300 may be cooled.

In an embodiment, when being held on the electronic device 100, the second external device 300 may be spaced apart from the first area 112a (or the through-hole 113) of the second passage part 112 by a specific interval. For example, a support boss 114 may protrude in the first area 112a of the second passage part 112. The second external device 300 may contact the support boss 114. For example, the second external device 300 may be spaced apart from the first area 112a to prevent the through-hole 113 from being blocked while contacting the support boss 114. The air that passes through the through-hole 113 may be discharged to the outside of the second housing 110 through a spaced space between the first area 112a and the second external device 300, and may cool the heat generated by the second external device 300.

Although not illustrated, in an embodiment, the electronic device 100 may include a pogo pin or a connector for charging the second external device 300 when the second external device 300 is held on the electronic device 100. For example, the second external device 300 may receive electric power from the electronic device 100 in a state, in which it is held on the electronic device 100.

In an embodiment, the second external device 300 may be referenced as a portable communication device (e.g., a smartphone, a smart pad, or a tablet computer). For example, the second external device 300 may be configured to be connected to or interwork with the first external device 200 to support and/or assist various functions of the first external device 200. For example, the second external device 300 may be understood as a tethered device or a companion device of the first external device 200. In various embodiments, the first external device 200 may provide various functions (e.g., a holo call) by using resources of the second external device 300.

In an embodiment, the second external device 300 may communicate with the electronic device 100 and/or the first external device 200 in a short-distance wireless communication network environment. For example, the second external device 300 may be configured to be paired with the electronic device 100 and/or the first external device 200 through Bluetooth (BLE). In various embodiments, the second external device 300 may deliver temperature information of the interior of the second external device 300 to the electronic device 100.

According to an embodiment, the second external device 300 may include at least some of the configurations of the electronic device 501 of FIG. 15. For example, the second external device 300 may include at least one of a display (e.g., a display module 560 of FIG. 15), a camera (e.g., a camera module 580 of FIG. 15), a least one sensor (e.g., a sensor module 576 of FIG. 15), a processor (e.g., a processor 520 of FIG. 15), a battery (e.g., a battery 589 of FIG. 15), a memory (e.g., a memory 530 of FIG. 15), or a communication circuit (e.g., a communication module 590 of FIG. 15). At least some of the components of the second external device 300 may be located in the interior of the second external device 300 or may be exposed to the outside of the housing.

FIG. 11 is a block diagram of the electronic device 100, the first external device 200, and the second external device 300 according to an embodiment.

The electronic device 100 illustrated in FIG. 11 may be referenced as the electronic device 100 illustrated in FIGS. 1, and 3 to 10, the first external device 200 may be referenced as the first external device 200 illustrated in FIGS. 1 and 2, and the second external device 300 may be referenced as the second external device 300 illustrated in FIGS. 9 and 10.

FIG. 11 is a block diagram illustrating components that are not illustrated in FIGS. 1 to 10, other than the components (e.g., the second housing 110, the first housing 120, the cooling fan 130, and the hinge 140) of the electronic device 100 described above with reference to FIGS. 1 to 10.

Referring to FIG. 11, the electronic device 100 according to an embodiment may include the driving part 150, a sensor part 160, a communication part 170, the controller 180, and the battery 190. In an embodiment, the communication part 170 and the controller 180 may be mounted on a printed circuit board (not illustrated) disposed in the interior of the electronic device 100. In various embodiments, at least one of the components of the electronic device 100 may be omitted, or one or more other components (e.g., a memory) may be further included.

In an embodiment, the electronic device 100 may be configured to communicate with the first external device 200 and/or the second external device 300.

In an embodiment, the electronic device 100 may communicate with the first external device 200 in a first network (101) environment. For example, the first network 101 may include a wired communication network and/or a wireless communication network. In various embodiments, the electronic device 100 may receive temperature information of the first external device 200 from the first external device 200 through the first network 101.

In an embodiment, the first network 101 may include a power line communication (PLC). For example, the electronic device 100 may be configured to communicate with the first external device 200 received in the interior thereof through power lines, through contact with the charging terminal (e.g., the pogo pin or the charging pad). In various embodiments, the electronic device 100 may receive a temperature of the first external device 200 through a power line communication. As another example, the first network 101 may include a short-distance communication network, such as Bluetooth, BLE, wireless fidelity (WiFi) direct, or infrared data association (IrDA).

In an embodiment, the electronic device 100 may communicate with the second external device 300 in a second network environment 103. For example, the second network 103 may include a short-distance communication network, such as Bluetooth, BLE, wireless fidelity (WiFi) direct, or infrared data association (IrDA). In various embodiments, the electronic device 100 may receive temperature information of the second external device 300 from the second external device 300 through the second network 103.

In an embodiment, the driving part 150 (e.g., a motor) may provide a driving force for driving the cooling fan (e.g., the cooling fan 130 of FIGS. 3, 6, and 8). For example, the driving part 150 may be connected to the wing parts (not illustrated) of the cooling fan 130, and may be configured to rotate the wing parts. An operation of the driving part 150 may be controlled by the controller 180. In various embodiments, whether the driving part 150 is operated, and a rotational speed of the driving part 150 may be determined by the controller 180. For example, whether the driving part 150 is operated and a rotational speed of the driving part 150 may be determined by the controller 180 based on a temperature of the external device (e.g., the first external device 200 and the second external device 300) that is to be cooled.

In an embodiment, the sensor part 160 may generate an electrical signal or a data value corresponding to an operational state (e.g., the opened state or the closed state) of the electronic device 100 or an external environment state (e.g., whether the second external device 300 is held/seated). For example, the sensor module may include at least one of a proximity sensor, an HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illumination sensor.

In an embodiment, the sensor part 160 may detect whether the electronic device 100 is in the opened state or the closed state, and may generate an electrical signal or data corresponding to the detected state. For example, the sensor part 160 may include a Hall sensor disposed in any one of the cover (e.g., the second housing 110 of FIGS. 1 to 10) and the housing (e.g., the first housing 120 of FIGS. 1 to 10), and a magnet disposed in the other, and the controller 180 may recognize a state of the electronic device 100 based on a change in an electromagnetic force of the magnet detected by the Hall sensor.

In an embodiment, the sensor part 160 may detect that the second external device 300 is held on the electronic device 100 when the electronic device 100 is in the opened state, and may generate an electrical signal or data corresponding to the detected state. For example, the sensor part 160 may include a proximity sensor or a Hall sensor disposed in the second housing 110, and may detect whether the second external device 300 is held. In various embodiments, the proximity sensor or the Hall sensor may be disposed in the second passage part 112 of the second housing 110, which contacts the second external device 300, when the second external device 300 is held. However, the kind and/or the location of the sensor part 160 for detecting whether the second external device 300 is held is not limited to the above-described example. According to various embodiments of the disclosure, the electronic device 100 may recognize whether the second external device 300 is held, by using NFC or a wireless charging coil (e.g., a Tx-coil).

In an embodiment, the sensor part 160 may include a temperature sensor, and may measure a temperature of the first external device 200 and/or the second external device 300 through a temperature sensor. For example, the temperature sensor may be disposed to measure a temperature of a heat emitting source (e.g., a display, a communication circuit, or a PMIC) of the first external device 200 and/or the second external device 300 when the first external device 200 and/or the second external device 300 is held on the electronic device.

In an embodiment, the communication part 170 may support wireless communication between the electronic device 100 and the external electronic device 100. For example, the wireless communication may be short-distance wireless communication, and for example, may include Bluetooth Standard, Bluetooth low energy (BLE), WiFi direct, or infrared data association (IrDA). The communication part 170 may be connected to the controller 180. An antenna conductor (or an antenna radiator) that is not illustrated in the drawings may be separately provided in the communication part 170 according to an embodiment to be connected thereto. In the disclosure, "connected" may mean that a (e.g., a first) component is directly, indirectly, communicatively, electrically, or operatively connected to another (e.g., a second) component. Here, "operatively connected" may mean that a (e.g., a first) component influences another (e.g., a second) component. As another example, an antenna conductor (or an antenna radiator) may be integrated in the communication part 170. As another example, the communication part 170 may be implemented in a form of a single or a plurality of chips.

In an embodiment, the controller 180 may control at least one other component (e.g., the driving part 150) of the electronic device 100, which is connected to the controller 180, and may perform various data processing or calculations. According to an embodiment, for at least some of the data processing or calculations, the controller 180 may load, process, and store commands or data received from another component (e.g., the sensor part 160 or the communication part 170). According to an embodiment, the controller 180 may include a main processor, and an auxiliary processor that may be operated independently or together therewith. Hereinafter, a description of other features of the controller 180 may be replaced by a description of a processor (e.g., a processor 520 of FIG. 15) illustrated in FIG. 15.

In an embodiment, the controller 180 may recognize whether the first external device 200 is received and/or whether the second external device 300 is held. For example, the controller 180 may recognize whether the first external device 200 is received, through a PLD communication with the first external device 200. For example, the controller 180 may recognize whether the second external device 300 is held, through the sensor part 160. However, the method for the controller 180 recognizing whether the first external device 200 is received and whether the second external device 300 is held is not limited to the above-described example, and may be implemented through various methods.

In an embodiment, the controller 180 may receive temperature information from the first external device 200 and the second external device 300, and may control the driving part 150 based on the temperature information. For example, the controller 180 may receive first temperature information of the first external device 200 through a PLC communication. For example, the controller 180 may receive second temperature information of the first external device 200 and/or the second external device 300 through a Bluetooth communication. The controller 180 may operate the driving part 150 to cool the first external device 200 or the second external device 300 when the fist temperature information or the second temperature information is a specific temperature or more. In various embodiments, the controller 180 may control a rotational speed of the driving part 150 (or the cooling fan 130) based on the first temperature information and the second temperature information.

In an embodiment, the battery 190 may be disposed in the interior of the electronic device 100 and may be electrically connected to a printed circuit board of the electronic device 100. The battery 190 may supply electric power to at least one element of the electronic device 100, and may charge the first external device 200 received in the interior of the electronic device 100. In an embodiment, the battery 190 may receive electric power from an external electronic device (e.g., a charging device) to be charged. The battery 190 may supply electric power to the first external device 200 received in the electronic device 120. In various embodiments, the battery 190 may include a rechargeable secondary battery or a fuel cell.

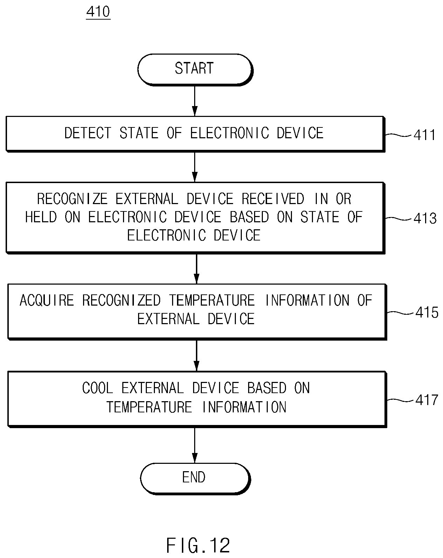

FIG. 12 illustrates a method 410 for operating an electronic device according to an embodiment.

FIG. 12 is a flowchart illustrating an operation method for the electronic device (e.g., the electronic device 100 of FIGS. 1 to 11) cooling the external device (e.g., the first external device 200 of FIGS. 1, 2, and 11 or the second external device 300 of FIGS. 9 and 11). Hereinafter, an operation of the electronic device may be referenced as an operation of the controller (e.g., the controller 180 of FIG. 11).

Referring to FIG. 12, the operation method 410 of the electronic device according to an embodiment may include an operation 411 of detecting a state of the electronic device, an operation 413 of recognizing an external device received in or held on the electronic device, an operation 415 of acquiring temperature information of the external device, and an operation 417 of cooling the external device based on the temperature information.

According to an embodiment, in the operation 411 of detecting the state of the electronic device, the electronic device may detect whether the electronic device is in the closed state (e.g., the state of FIG. 3) of the opened state (e.g., the state of FIG. 4). For example, the electronic device 100 may detect whether the cover is closed or opened, through the sensor part (e.g., the sensor part 160 of FIG. 11).

According to an embodiment, in the operation 413 of recognizing the external device received in or held on the electronic device may recognize the external device received in or held on the electronic device based on the state of the electronic device. For example, the electronic device may detect whether the first external device is received in the closed state, and may recognize the first external device accommodated in the interior of the electronic device. For example, the electronic device may detect whether the first external device is received and the second external device is held in the opened state, and may recognize the first external device accommodated in the interior of the electronic device or the second external device held on the electronic device. In various embodiments, in the operation 413 of recognizing the external device, the electronic device may communicate with the first external device and/or the second external device.

According to an embodiment, in the operation 415 of acquiring the temperature information of the external device, the electronic device may acquire the temperature information of the first external device or the second external device. For example, the electronic device may acquire first temperature information that is temperature information of the first external device through a communication (e.g., PLD) when recognizing the first external device. For example, the electronic device may acquire second temperature information that is temperature information of the second external device through a communication (e.g., BLE) when recognizing the second external device.

According to an embodiment, in the operation 417 of cooling the external device based on the temperature information, the electronic device may operate the cooling fan based on the temperature information. The electronic device may adjust a rotational speed of the cooling fan based on the temperature information. For example, the electronic device may operate the cooling fan when the first temperature information of the first external device or the second temperature information of the second external device is higher than a specific temperature, and a rotational speed of the cooling fan may be controlled based on the first temperature information and the second temperature information. In various embodiments, the electronic device may acquire change information on an increase or a decrease in the temperature information off the first external device and the second external device, and may control the rotational speed of the cooling fan based on the change information.

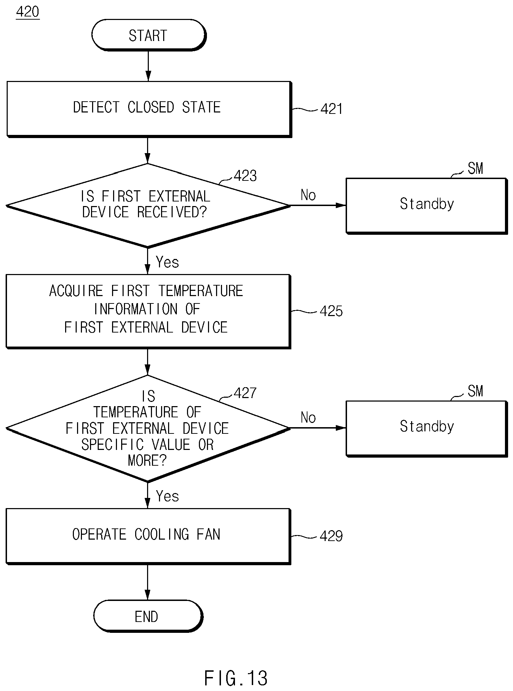

FIG. 13 illustrates an operation method 420 of the electronic device according to an embodiment.

Some of the operations included in the operation method 420 of FIG. 13 may be the same as or similar to some of the operations included in the operation method 410 of FIG. 12, and a repeated description thereof will be omitted hereinafter.

Referring to FIG. 13, the operation method 420 of the electronic device according to an embodiment may include an operation 421 of detecting the closed state, an operation 423 of recognizing whether the first external device is received, an operation 425 of acquiring first temperature information of the first external device, an operation 427 of determining whether a temperature of the first external device is a specific value or more, and an operation 429 of operating the cooling fan.

According to an embodiment, in the operation 421 of detecting the closed state, the electronic device may detect the closed state (e.g., the state of FIG. 3) of the electronic device. For example, the electronic device may detect whether the electronic device is in the closed state, through the sensor part (e.g., the sensor part 160 of FIG. 11).

According to an embodiment, in the operation 423 of recognizing whether the first external device is received, the electronic device may recognize whether the first external device is received in the interior of the electronic device. For example, the electronic device may recognize whether the first external device is received, based on whether the charging terminal (e.g., a pogo pin) of the first external device is in contact with the charging terminal (e.g., a charging pad) of the electronic device. In an embodiment, the electronic device may perform then operation 425 of acquiring the first temperature information when it is recognized that the first external device is received (Yes). In an embodiment, the electronic device may perform then operation 425 of acquiring the first temperature information when it is recognized that the first external device is received (Yes). For example, an aspect that "the electronic device is operated in a standby mode (SM)" may be understood that "the electronic device does not take any operation (or measure).

According to an embodiment, in the operation 425 of acquiring the first temperature information of the first external device, the electronic device may acquire the first temperature information of the first external device. The first temperature information may include a value related to the temperature of the first external device. For example, the electronic device may communicate with the first external device through the power line communication (PLC), and may receive the first temperature information from the first external device. However, the method for communication of the electronic device and the first external device is not limited to the above-described example, and may be implemented by using various communication means.

According to an embodiment, in the operation 427 of determining whether the temperature of the first external device is a specific value or more, the electronic device may determine whether the temperature of the first external device is a specific value or more, based on the first temperature information. For example, the electronic device may determine whether the temperature of the first external device is a specific value range or more, based on the first temperature information acquired from the first external device. In an embodiment, the electronic device may perform the operation 429 of operating the cooling fan when it is determined that the temperature of the first external device is higher than a specific value (Yes). The electronic device may be operated in the standby mode (SM) when it is determined that the temperature of the first external device is lower than a specific value (No).

According to an embodiment, in the operation 429 of operating the cooling fan, the electronic device may operate the cooling fan. For example, the electronic device may cool the heat generated from the first external device by operating the cooling fan when it is determined that the temperature of the external device is high. The electronic device may adjust a rotational speed of the cooling fan based on the first temperature information acquired from the first external device.

Although not illustrated, according to an embodiment, the electronic device may perform an operation of periodically measuring the temperature of the first external device. For example, because the temperature of the first external device may be increased when the first external device is charged through the electronic device, the electronic device may periodically measure the temperature of the first external device when the first external device is received in the electronic device. As another example, because the temperature of the electronic device is raised as the electronic device transmits electric power to the first external device, the electronic device may periodically measure the temperature of the electronic device and the electronic device may operate the cooling fan when the temperature of the electronic device is a specific temperature or more.

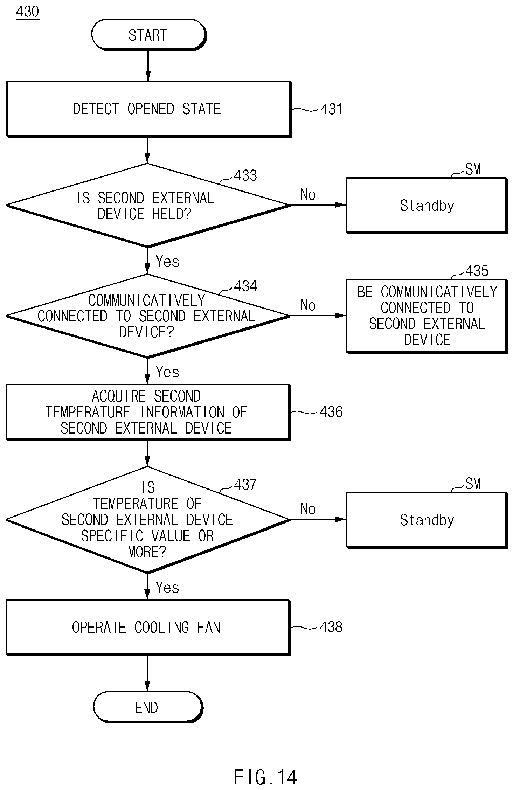

FIG. 14 illustrates an operation method 430 of the electronic device according to an embodiment.

Some of the operations included in the operation method 430 of FIG. 14 may be the same as or similar to some of the operations included in the operation method 410 of FIG. 12, and a repeated description thereof will be omitted hereinafter.

Referring to FIG. 14, the operation method 430 of the electronic device according to an embodiment may include an operation 431 of detecting an opened state, an operation 433 of recognizing whether the second external device is held, an operation 434 of recognizing communication connection of the second external device, an operation 435 of being communicatively connected to the second external device, an operation 436 of acquiring second temperature information of the second external device, an operation 437 of determining whether the temperature of the second external device is a specific value or more, and an operation 438 of operating the cooling fan.

According to an embodiment, in the operation 431 of detecting the opened state, the electronic device may detect the opened state (e.g., the state of FIG. 4). For example, the electronic device may detect whether the electronic device is in the opened state through the sensor part (e.g., the sensor part 160 of FIG. 11).

According to an embodiment, in the operation 433 of recognizing whether the second external device is held, the electronic device may recognize whether the second external device is held on the electronic device. For example, the electronic device 100 may detect the second external device through the sensor part (e.g., the sensor part 160 of FIG. 11). For example, the electronic device may recognize whether the second external device is held, by using a proximity sensor, a Hall sensor, an NFC, or a wireless charging coil disposed in the second housing 110 of the electronic device (e.g., the second housing 110 of FIGS. 9 and 10). In an embodiment, the electronic device may perform the operation 434 of recognizing a communication connection of the second external device when recognizing that the second external device is held (Yes). The electronic device may be operated in the standby mode (SM) when it is recognized that the second external device is not held (No). For example, an aspect that "the electronic device is operated in the standby mode (SM)) may be understood that "the electronic device does not take any operation (or measure).

According to an embodiment, in the operation 434 of recognizing a communication connection of the second external device, the electronic device may recognize whether it is communicatively linked with the second external device. The electronic device may communicate with the second external device through a short-distance wireless communication network. For example, the electronic device may be paired with the second external device through Bluetooth. In an embodiment, the electronic device may perform the operation 426 of acquiring the second temperature information of the second external device when it is recognized that it is communicatively connected (paired) with the second external device (Yes). The electronic device may perform the operation 435 of being communicatively connected to the second external device when it is recognized that it is not communicatively connected to the second external device.

According to an embodiment, in the operation 435 of being communicatively connected to the second external device, the electronic device may be connected to the second external device to communicate therewith. For example, in the operation 435 of being communicatively connected to the second external device, the electronic device and the second external device may be paired with each other through Bluetooth. The electronic device may perform the operation 436 of acquiring the second temperature information through communication with the second external device, after the operation 435 of the communicative connection. However, the method for communication of the electronic device and the second external device is not limited to the above-described example, and may be implemented by using various communication means.

In an embodiment, in the operation 436 of acquiring the second temperature information of the second external device, the electronic device may acquire the second temperature information of the second external device. The second temperature information may include a value related to the temperature of the second external device. For example, the electronic device may communicate with the second external device through Bluetooth, and may receive the second temperature information from the second external device.

According to an embodiment, in the operation 437 of determining whether the temperature of the second external device is a specific value or more, the electronic device may determine whether the temperature of the second external device is a specific value or more, based on the second temperature information. For example, the electronic device may determine whether the temperature of the second external device is a specific value range or more, based on the second temperature information acquired from the second external device. In an embodiment, the electronic device may perform the operation 438 of operating the cooling fan when it is determined that the temperature of the second external device is higher than a specific value (Yes). The electronic device may be operated in the standby mode (SM) when it is determined that the temperature of the second external device is lower than a specific value (No).

According to an embodiment, in the operation 438 of operating the cooling fan, the electronic device may operate the cooling fan. For example, the electronic device may cool the heat generated from the second external device by operating the cooling fan when it is determined that the temperature of the second external device is high. The electronic device may adjust a rotational speed of the cooling fan based on the second temperature information acquired from the second external device.

FIG. 15 is a block diagram of an electronic device 501 in a network environment 500 according to various embodiments.

The electronic device 501 of FIG. 15 may be referenced as the first external device 200 of FIGS. 1, 2, and 11 or the second external device 300 of FIGS. 9 and 11. For example, when the electronic device 501 is referenced as the first external device 200, the electronic device 502 or the electronic device 504 may be the second electronic device 300 or the electronic device of FIGS. 1, 9, and 11. As another example, when the electronic device 501 is referenced as the second external device 300, the electronic device 502 or the electronic device 504 may be the first external device 200 or the electronic device 100 of FIGS. 1, 9, and 11.

Referring to FIG. 15, an electronic device 501 in a network environment 100 may communicate with an electronic device 502 via a first network 598 (e.g., a short-range wireless communication network), or at least one of an electronic device 504 or a server 508 via a second network 599 (e.g., a long-range wireless communication network). According to an embodiment, the electronic device 501 may communicate with the electronic device 504 via the server 508. According to an embodiment, the electronic device 501 may include a processor 520, memory 530, an input module 550, a sound output module 555, a display module 560, an audio module 570, a sensor module 576, an interface 577, a connecting terminal 578, a haptic module 579, a camera module 580, a power management module 588, a battery 189, a communication module 590, a subscriber identification module (SIM) 596, or an antenna module 597. In some embodiments, at least one of the components (e.g., the connecting terminal 578) may be omitted from the electronic device 501, or one or more other components may be added in the electronic device 501. In some embodiments, some of the components (e.g., the sensor module 576, the camera module 580, or the antenna module 597) may be implemented as a single component (e.g., the display module 560).

The processor 520 may execute, for example, software (e.g., a program 540) to control at least one other component (e.g., a hardware or software component) of the electronic device 501 coupled with the processor 520, and may perform various data processing or computation. According to one embodiment, as at least part of the data processing or computation, the processor 520 may store a command or data received from another component (e.g., the sensor module 576 or the communication module 590) in volatile memory 532, process the command or the data stored in the volatile memory 532, and store resulting data in non-volatile memory 534. According to an embodiment, the processor 520 may include a main processor 521 (e.g., a central processing unit (CPU) or an application processor (AP)), or an auxiliary processor 523 (e.g., a graphics processing unit (GPU), a neural processing unit (NPU), an image signal processor (ISP), a sensor hub processor, or a communication processor (CP)) that is operable independently from, or in conjunction with, the main processor 521. For example, when the electronic device 501 includes the main processor 521 and the auxiliary processor 523, the auxiliary processor 523 may be adapted to consume less power than the main processor 521, or to be specific to a specified function. The auxiliary processor 523 may be implemented as separate from, or as part of the main processor 521.

The auxiliary processor 523 may control at least some of functions or states related to at least one component (e.g., the display module 560, the sensor module 576, or the communication module 590) among the components of the electronic device 501, instead of the main processor 521 while the main processor 521 is in an inactive (e.g., sleep) state, or together with the main processor 521 while the main processor 521 is in an active state (e.g., executing an application). According to an embodiment, the auxiliary processor 523 (e.g., an image signal processor or a communication processor) may be implemented as part of another component (e.g., the camera module 580 or the communication module 590) functionally related to the auxiliary processor 523. According to an embodiment, the auxiliary processor 523 (e.g., the neural processing unit) may include a hardware structure specified for artificial intelligence model processing. An artificial intelligence model may be generated by machine learning. Such learning may be performed, e.g., by the electronic device 501 where the artificial intelligence is performed or via a separate server (e.g., the server 508). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 530 may store various data used by at least one component (e.g., the processor 520 or the sensor module 576) of the electronic device 501. The various data may include, for example, software (e.g., the program 540) and input data or output data for a command related thereto. The memory 530 may include the volatile memory 532 or the non-volatile memory 534.

The program 540 may be stored in the memory 530 as software, and may include, for example, an operating system (OS) 142, middleware 144, or an application 546.

The input module 550 may receive a command or data to be used by another component (e.g., the processor 520) of the electronic device 501, from the outside (e.g., a user) of the electronic device 501. The input module 550 may include, for example, a microphone, a mouse, a keyboard, a key (e.g., a button), or a digital pen (e.g., a stylus pen).

The sound output module 555 may output sound signals to the outside of the electronic device 501. The sound output module 555 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 560 may visually provide information to the outside (e.g., a user) of the electronic device 501. The display module 560 may include, for example, a display, a hologram device, or a projector and control circuitry to control a corresponding one of the display, hologram device, and projector. According to an embodiment, the display module 560 may include a touch sensor adapted to detect a touch, or a pressure sensor adapted to measure the intensity of force incurred by the touch.

The audio module 570 may convert a sound into an electrical signal and vice versa. According to an embodiment, the audio module 570 may obtain the sound via the input module 550 , or output the sound via the sound output module 555 or a headphone of an external electronic device (e.g., an electronic device 502) directly (e.g., wiredly) or wirelessly coupled with the electronic device 501.

The sensor module 576 may detect an operational state (e.g., power or temperature) of the electronic device 501 or an environmental state (e.g., a state of a user) external to the electronic device 501, and then generate an electrical signal or data value corresponding to the detected state. According to an embodiment, the sensor module 576 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 577 may support one or more specified protocols to be used for the electronic device 501 to be coupled with the external electronic device (e.g., the electronic device 502) directly (e.g., wiredly) or wirelessly. According to an embodiment, the interface 577 may include, for example, a high definition multimedia interface (HDMI), a universal serial bus (USB) interface, a secure digital (SD) card interface, or an audio interface.

A connecting terminal 578 may include a connector via which the electronic device 501 may be physically connected with the external electronic device (e.g., the electronic device 502). According to an embodiment, the connecting terminal 578 may include, for example, a HDMI connector, a USB connector, a SD card connector, or an audio connector (e.g., a headphone connector).

The haptic module 579 may convert an electrical signal into a mechanical stimulus (e.g., a vibration or a movement) or electrical stimulus which may be recognized by a user via his tactile sensation or kinesthetic sensation. According to an embodiment, the haptic module 579 may include, for example, a motor, a piezoelectric element, or an electric stimulator.

The camera module 580 may capture a still image or moving images. According to an embodiment, the camera module 580 may include one or more lenses, image sensors, image signal processors, or flashes.

The power management module 588 may manage power supplied to the electronic device 501. According to one embodiment, the power management module 588 may be implemented as at least part of, for example, a power management integrated circuit (PMIC).

The battery 589 may supply power to at least one component of the electronic device 501. According to an embodiment, the battery 589 may include, for example, a primary cell which is not rechargeable, a secondary cell which is rechargeable, or a fuel cell.

The communication module 590 may support establishing a direct (e.g., wired) communication channel or a wireless communication channel between the electronic device 501 and the external electronic device (e.g., the electronic device 502, the electronic device 504, or the server 508) and performing communication via the established communication channel. The communication module 590 may include one or more communication processors that are operable independently from the processor 520 (e.g., the application processor (AP)) and supports a direct (e.g., wired) communication or a wireless communication. According to an embodiment, the communication module 590 may include a wireless communication module 592 (e.g., a cellular communication module, a short-range wireless communication module, or a global navigation satellite system (GNSS) communication module) or a wired communication module 594 (e.g., a local area network (LAN) communication module or a power line communication (PLC) module). A corresponding one of these communication modules may communicate with the external electronic device via the first network 598 (e.g., a short-range communication network, such as Bluetooth^{™}, wireless-fidelity (Wi-Fi) direct, or infrared data association (IrDA)) or the second network 599 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 592 may identify and authenticate the electronic device 501 in a communication network, such as the first network 598 or the second network 599, using subscriber information (e.g., international mobile subscriber identity (IMSI)) stored in the subscriber identification module 596.

The wireless communication module 592 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 592 may support a high-frequency band (e.g., the millimeter (mm) Wave band) to achieve, e.g., a high data transmission rate. The wireless communication module 592 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 592 may support various requirements specified in the electronic device 501, an external electronic device (e.g., the electronic device 504), or a network system (e.g., the second network 599). According to an embodiment, the wireless communication module 592 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 597 may transmit or receive a signal or power to or from the outside (e.g., the external electronic device) of the electronic device 501. According to an embodiment, the antenna module 597 may include an antenna including a radiating element composed of a conductive material or a conductive pattern formed in or on a substrate (e.g., a printed circuit board (PCB)). According to an embodiment, the antenna module 597 may include a plurality of antennas (e.g., array antennas). In such a case, at least one antenna appropriate for a communication scheme used in the communication network, such as the first network 598 or the second network 599, may be selected, for example, by the communication module 590 (e.g., the wireless communication module 592) from the plurality of antennas. The signal or the power may then be transmitted or received between the communication module 590 and the external electronic device via the selected at least one antenna. According to an embodiment, another component (e.g., a radio frequency integrated circuit (RFIC)) other than the radiating element may be additionally formed as part of the antenna module 597.

According to various embodiments, the antenna module 597 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 501 and the external electronic device 504 via the server 508 coupled with the second network 599. Each of the electronic devices 502 or 504 may be a device of a same type as, or a different type, from the electronic device 501. According to an embodiment, all or some of operations to be executed at the electronic device 501 may be executed at one or more of the external electronic devices 502 504, or 508. For example, if the electronic device 501 should perform a function or a service automatically, or in response to a request from a user or another device, the electronic device 501, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 501. The electronic device 501 may provide the outcome, with or without further processing of the outcome, as at least part of a reply to the request. To that end, a cloud computing, distributed computing, mobile edge computing (MEC), or client-server computing technology may be used, for example. The electronic device 501 may provide ultra low-latency services using, e.g., distributed computing or mobile edge computing. In another embodiment, the external electronic device 504 may include an internet-of things (IoT) device. The server 508 may be an intelligent server using machine learning and/or a neural network. According to an embodiment, the external electronic device 504 or the server 508 may be included in the second network 599. The electronic device 501 may be applied to intelligent services (e.g., smart home, smart city, smart car, or healthcare) based on 5G communication technology or loT-related technology.

An electronic device 100 according to an embodiment disclosed in the disclosure may include a first housing 120 having a receiving space, in which a first external device is received, a second housing 110 coupled to the first housing to be rotatable, and a cooling fan 130 disposed in an interior space of the second housing, the electronic device may be deformed to a closed state and an opened state in correspondence to whether the second housing is opened or closed, the second housing may include a second passage part communicating the interior space of the second housing with the receiving space of the first housing, the first housing may include a first passage part communicated with the receiving space and to which at least a portion of the second passage part is connected in the closed state, in the closed state, wind generated by the cooling fan may flow to the receiving space through the first passage part and the second passage part, and the first external device may be received in the receiving space in the closed state to be cooled through the cooling fan.

In various embodiments, the first housing 120 may have at least one first vent hole 121 communicating the receiving space 124 and an outside of the first housing, at at least a portion of an outer surface of the first housing, and the second housing 110 may have at least one second vent hole 111 communicating the interior space 116 and an outside of the second housing, at at least a portion of an outer surface of the second housing.

In various embodiments, air outside the second housing 110 may be introduced into the interior space through the second vent hole 111 through an operation of the cooling fan 130, and the air introduced into the interior space of the second housing may flow to an outside of the interior space partially through the second passage part 112.

In various embodiments, in the closed state, the air introduced into the interior space 116 may flow to the receiving space 124 partially through the first passage part 125 and the second passage part 112, and the air that flows to the receiving space may flow to an outside of the first housing 120 partially through the first vent hole 121.

In various embodiments, the second housing 110 may include a first surface 110e, and a second surface 110f facing an opposite direction to the first surface, the second surface may partially face the receiving space in the closed state, and the second passage part 112 may protrude from the second surface to be substantially perpendicular thereto.

In various embodiments, the first passage part 125 may include a first opening 126, into which at least a portion of the second passage part 112 is inserted in the closed state, and at least one second opening 127 connecting the first opening and the receiving space.

In various embodiments, the first passage part may include a first area 125a facing the second surface 110f of the second housing 110 in the closed state, and a second area 125b extending from the first area to be substantially perpendicular thereto and defining at least a portion of an inner surface of the first housing 120, the first opening 126 may pass through at least a portion of the first area, and the second opening 127 may pass through at least a portion of the second area to connect the first opening and the receiving space 124.

In various embodiments, the first opening 126 of the first passage part 125 may be formed to have a shape corresponding to that of the second passage part 112, and is formed at a location of the first area 125a of the first passage part, which is aligned with that of the second passage part in the closed state.

In various embodiments, the second passage part 112 may include at least one through-hole 113 connected to the interior space 116.

In various embodiments, the closed is a state, in which a peripheral portion of the first housing 120 and a peripheral portion of the second housing 110 are substantially in contact with each other, and the opened state may be a state, in which a portion of the peripheral portion of the first housing 120 and a portion of the peripheral portion of the second housing 110 form a specific included angle A1.

In various embodiments, a second external device 300 that is different from the first external device 200 may be held in the opened state, and the second external device may be cooled by the cooling fan 130 in a state while being held on the electronic device 100.

In various embodiments, in the opened state, at least a portion of the second external device 300 may be supported by the receiving space 124, and another portion thereof supported by the second passage part 112 of the second housing 110 to be held on the electronic device 110.

In various embodiments, the electronic device may further include a controller 180 disposed in the first housing 120 or the second housing 110, and the controller may be configured to control an operation or a rotational speed of the cooling fan 130 based on first temperature information related to a temperature of the first external device 200 or second temperature information related to a temperature of the second external device 300.

In various embodiments, the electronic device 100 may be configured to communicate with the first external device 200 and the second external device 300, and the controller 180 may be configured to communicate with the first external device to acquire the first temperature information from the first external device and communicate with the second external device to acquire the second temperature information from the second external device.

In various embodiments, the electronic device may further include a controller 180 disposed in the first housing 120 or the second housing 110, the controller may be configured to detect the closed state or the opened state of the electronic device, recognize the first external device or the second external device received in or held on the electronic device, based on a state of the electronic device, acquire temperature information of the first external device 200 or the second external device 300, and control an operation and a rotational speed of the cooling fan 130 based on the acquired temperature information.

In various embodiments, the controller 180 may be configured to detect that the electronic device 100 is in the closed state, recognize whether the first external device 200 is received, acquire first temperature information related to a temperature of the first external device from the first external device, and operate the cooling fan 130 when a temperature of the first external device is a specific temperature or higher, based on the first temperature information.

In various embodiments, the controller may be configured to detect that the electronic device 100 is in the opened state, recognize whether the second external device is held, acquire second temperature information related to a temperature of the second external device, from the second external device, and operate the cooling fan 130 when a temperature of the second external device is a specific temperature or higher, based on the second temperature information.

In various embodiments, an operation method 410 of an electronic device 100 including the cooling fan 130 according to an embodiment disclosed in the disclosure may include an operation of detecting a closed state or an opened state of the electronic device, an operation of recognizing a first external device 200 or a second external device 300 received in or held on the electronic device based on a state of the electronic device, an operation of acquiring temperature information of the first external device or the second external device, and an operation of controlling an operation and a rotational speed of the cooling fan 130 based on the acquired temperature information.

In various embodiments, an operation method 420 of the electronic device 100 may include an operation of detecting the closed state by the electronic device, an operation of recognizing whether the first external device 200 is received, an operation of acquiring first temperature information related to a temperature of the first external device from the first external device, and an operation of cooling the cooling fan 130 when the temperature of the first external device is a specific temperature or more, based on the first temperature information.

In various embodiments, an operation method 430 of the electronic device may include an operation of detecting that the electronic device is in the opened state, an operation of recognizing whether the second external device 300 is held, an operation of acquiring second temperature information related to a temperature of the second external device from the second external device, and an operation of operating the cooling fan when the temperature of the second external device is a specific temperature or more, based on the second temperature information.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program140) including one or more instructions that are stored in a storage medium (e.g., internal memory 136 or external memory 138) that is readable by a machine (e.g., the electronic device 501). For example, a processor (e.g., the processor 520) of the machine (e.g., the electronic device 501) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first housing having a receiving space, in which a first external device is received;
a second housing coupled to the first housing to be rotatable; and
a cooling fan disposed in an interior space of the second housing,
wherein the electronic device is configured to be deformed to a closed state and an opened state in correspondence to whether the second housing is opened or closed,
wherein the second housing includes a second passage part communicating the interior space of the second housing with the receiving space of the first housing,
wherein the first housing includes a first passage part communicated with the receiving space and to which at least a portion of the second passage part is connected in the closed state,
wherein, in the closed state, wind generated by the cooling fan flows to the receiving space through the first passage part and the second passage part, and
wherein the first external device is configured to be received in the receiving space in the closed state to be cooled through the cooling fan.

2. The electronic device of claim 1, wherein the first housing has at least one first vent hole communicating the receiving space and an outside of the first housing, at at least a portion of an outer surface of the first housing, and
wherein the second housing has at least one second vent hole communicating the interior space and an outside of the second housing, at at least a portion of an outer surface of the second housing.

3. The electronic device of claim 2, wherein air outside the second housing is introduced into the interior space through the second vent hole through an operation of the cooling fan, and
wherein the air introduced into the interior space of the second housing flows to an outside of the interior space partially through the second passage part.

4. The electronic device of claim 3, wherein in the closed state,
the air introduced into the interior space flows to the receiving space partially through the first passage part and the second passage part, and
the air that flows to the receiving space flows to an outside of the first housing partially through the first vent hole.

5. The electronic device of claim 1, wherein the second housing includes a first surface, and a second surface facing an opposite direction to the first surface,
wherein the second surface partially faces the receiving space in the closed state, and
wherein the second passage part protrudes from the second surface to be substantially perpendicular thereto.

6. The electronic device of claim 5, wherein the first passage part includes:
a first opening, into which at least a portion of the second passage part is inserted in the closed state, and at least one second opening connecting the first opening and the receiving space.

7. The electronic device of claim 6, wherein the first passage part includes:
a first area facing the second surface of the second housing in the closed state, and a second area extending from the first area to be substantially perpendicular thereto and defining at least a portion of an inner surface of the first housing,
wherein the first opening passes through at least a portion of the first area, and
wherein the second opening passes through at least a portion of the second area to connect the first opening and the receiving space.

8. The electronic device of claim 7, wherein the first opening of the first passage part is formed to have a shape corresponding to that of the second passage part, and is formed at a location of the first area of the first passage part, which is aligned with that of the second passage part in the closed state.

9. The electronic device of claim 1, wherein the second passage part includes at least one through-hole connected to the interior space.

10. The electronic device of claim 1, wherein a second external device that is different from the first external device is configured to be held in the opened state, and
wherein the second external device is configured to be cooled by the cooling fan in a state while being held on the electronic device.

11. The electronic device of claim 10, wherein in the opened state,
at least a portion of the second external device is supported by the receiving space, and another portion thereof supported by the second passage part of the second housing to be held on the electronic device.

12. The electronic device of claim 10, further comprising:
a controller disposed in the first housing or the second housing, and
wherein the controller is configured to:
control an operation or a rotational speed of the cooling fan based on first temperature information related to a temperature of the first external device or second temperature information related to a temperature of the second external device.

13. The electronic device of claim 10, further comprising:
a controller disposed in the first housing or the second housing,
wherein the controller is configured to:
detect the closed state or the opened state of the electronic device;
recognize the first external device or the second external device received in or held on the electronic device, based on a state of the electronic device;
acquire temperature information of the first external device or the second external device; and
control an operation and a rotational speed of the cooling fan based on the acquired temperature information.

14. The electronic device of claim 13, wherein the controller is configured to:
detect that the electronic device is in the closed state;
recognize whether the first external device is received;
acquire first temperature information related to a temperature of the first external device from the first external device; and
operate the cooling fan when a temperature of the first external device is a specific temperature or higher, based on the first temperature information.

15. The electronic device of claim 13, wherein the controller is configured to:
detect that the electronic device is in the opened state;
recognize whether the second external device is held;
acquire second temperature information related to a temperature of the second external device, from the second external device; and
operate the cooling fan when a temperature of the second external device is a specific temperature or higher, based on the second temperature information.
